Europäisches Patentamt

European Patent Office

Office européen des brevets

(19)

(11) **EP 0 827 266 B1**

(12) **EUROPEAN PATENT SPECIFICATION**

(45) Date of publication and mention
of the grant of the patent:
**27.06.2001 Bulletin 2001/26**

(51) Int Cl.[7]: **H02P 7/00**, G01R 19/00

(21) Application number: **97101804.9**

(22) Date of filing: **05.02.1997**

(54) **High-side type motor current detecting circuit**

Motorstromdetektor an der hohen Seite der Spannung

Détecteur du courant d'un moteur, côté tension positive

(84) Designated Contracting States:
**DE FR GB**

(30) Priority: **29.08.1996 JP 22852496**

(43) Date of publication of application:
**04.03.1998 Bulletin 1998/10**

(73) Proprietor: **MITSUBISHI DENKI KABUSHIKI
KAISHA
Tokyo 100 (JP)**

(72) Inventors:
• **Yokoyama, Etsuya
Chiyoda-ku, Tokyo 100 (JP)**
• **Wada, Shunichi
Chiyoda-ku, Tokyo 100 (JP)**

(74) Representative:
**Ritter und Edler von Fischern, Bernhard,
Dipl.-Ing. et al
Hoffmann Eitle,
Patent- und Rechtsanwälte,
Arabellastrasse 4
81925 München (DE)**

(56) References cited:
**EP-A- 0 393 847          US-A- 4 494 181**

EP 0 827 266 B1

**Description**

BACKGROUND OF THE INVENTION

Field of the Invention

The present invention relates generally to a high-side type motor current detecting circuit which is employed for controlling an electric motor, for example, of a motor-driven power steering system for a motor vehicle. More specifically, the present invention is concerned with a high-side type motor current detecting circuit which can be inexpensively implemented in a simplified circuit configuration and which can ensure high reliability for the motor control by making it possible to detect a motor current with high accuracy.

Description of Related Art

Heretofore, in a motor-driven power steering system for a motor vehicle or the like, a high-side type motor current detecting circuit is employed for the purpose of controlling an electric motor which constitutes an assist torque generating source for the power steering system. As typical ones of such high-side type motor current detecting circuit, there may be mentioned those disclosed, for example, in Japanese Unexamined Patent Application Publications Nos. 80860/1996 (JP-A-8-80860) and 251596/1992 (JP-A-4-251596).

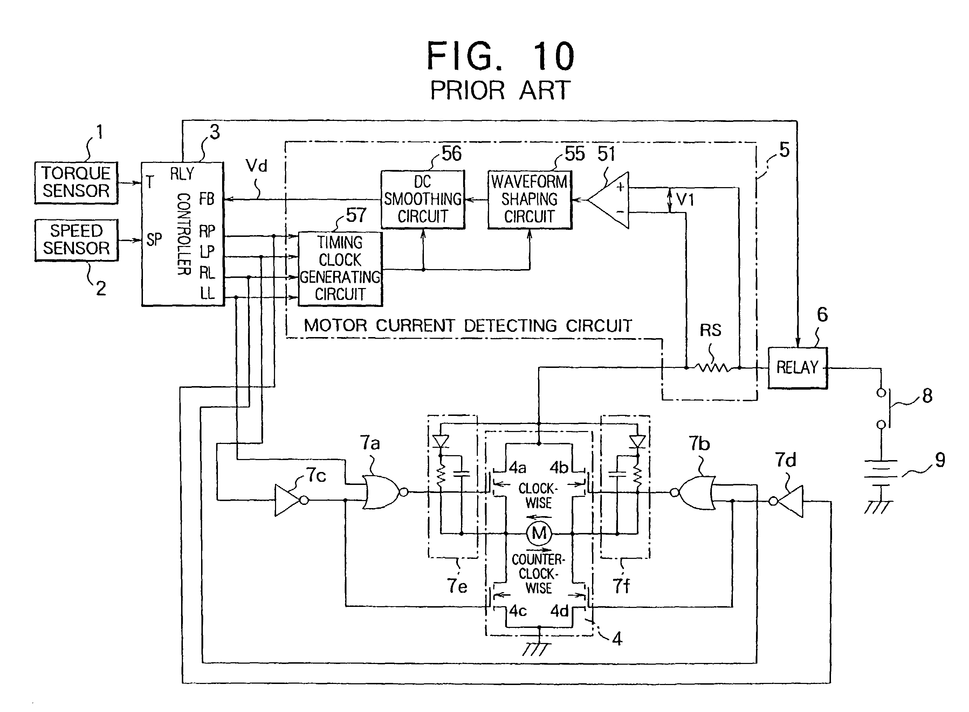

For having better understanding of the present invention, technical background thereof will be reviewed in some detail by reference to Fig. 10 which is a circuit diagram showing a conventional high-side type motor current detecting circuit such as disclosed in JP-A-8-80860.

Referring to the figure, a steering signal T indicative of a torque applied to a steering wheel of a motor vehicle and derived from a torque sensor 1 and a vehicle speed signal SP outputted from a speed sensor 2 are inputted to a controller 3 which is usually constituted by a microprocessor or microcomputer.

The controller 3 is so programmed as to generate a clockwise (Pulse-Width Modulated) PWM drive signal RP, a counterclockwise PWM drive signal LP, a clockwise drive inhibit signal RL or counterclockwise drive inhibit signal LL and a relay control signal RLY on the basis of the steering signal T and the vehicle speed signal SP which indicate the operation state of the motor vehicle.

The signals RP, LP, RL or LL outputted from the controller 3 is applied to individual FETs (Field-Effect Transistor) 4a, 4d; 4b, 4c constituting an H-bridge circuit 4 as FET driving signals by way of FET driving circuits, respectively, each of which is constituted by a combination of an inverter 7c, 7d and a NOR circuit 7a, 7b. The output voltage of the H-bridge circuit 4 is applied to an electric motor M. Thus, a corresponding motor current flows through the motor M to rotate it in the clockwise or counterclockwise direction.

Additionally, the aforementioned signals RP, LP, RL or LL outputted from the controller 3 is inputted to a timing clock generating circuit 57 incorporated in a motor current detecting circuit 5 while the relay control signal RLY is applied to a relay 6.

Inserted between a circuit point of high potential (i.e., high side) of the H-bridge circuit 4 and one end of the relay 6 is a shunt resistor Rs which has the other end connected to an anode of a power supply source such as an onboard battery 9 of the motor vehicle by way of an ignition switch 8 thereof. At this juncture, it is to be mentioned that because the shut resistor Rs serving for detecting the motor current of the electric motor M is disposed at the high potential side of the H-bridge circuit, the motor current detecting circuit under consideration is referred to as the high-side type motor current detecting circuit.

A voltage V1 detected across the shunt resistor Rs (hereinafter this voltage is referred to also as the shunt voltage for the convenience of description) is directly inputted to a differential amplifier 51 constituting a part of the motor current detecting circuit 5. Derived from the output of the differential amplifier 51 through a waveform shaping circuit 55 and a DC smoothing circuit 56 is a detection voltage Vd, which is outputted as the motor current detection signal from the motor current detecting circuit 5.

The detection voltage Vd which indicates the motor current flowing to and through the motor M is then inputted to the controller 3 as a feedback signal FB.

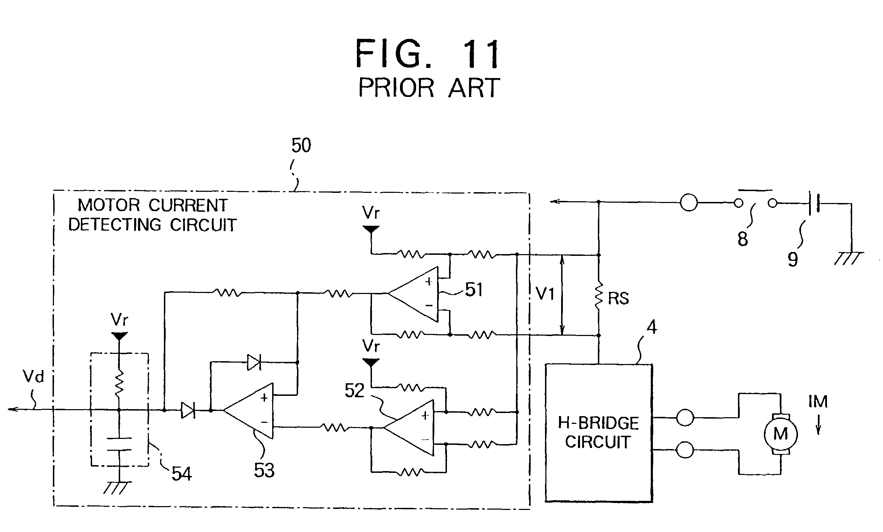

Further, Fig. 11 is a circuit diagram showing another conventional high-side type motor current detecting circuit such as disclosed in JP-A-4-251596. In the figure, like components as those mentioned above are denoted by like reference characters and repeated description thereof is omitted.

Referring to Fig. 11, a motor current detecting circuit 50 constitutes a motor control circuit in cooperation with an H-bridge circuit 4 and a shunt resistor Rs. On the other hand, an ignition switch 8 and a battery 9 cooperate with a relay 6 (not shown) to constitute a main power-supply circuit for supplying electric energy to a motor control circuit.

As can be seen in Fig. 11, the motor current detecting circuit 50 is composed of a pair of differential amplifiers 51 and 52 each having a non-inverting input terminal of plus (+) polarity to which a reference voltage Vr is applied, a comparator 53 having an inverting input terminal of minus (-) polarity to which the output signal of the differential amplifier 51 is applied and a non-inverting input terminal of plus (+) polarity to which the output signal of the differential amplifier 52 is applied, and a peak-hold circuit 54 for holding the output signal of the differential amplifier 51 which is higher than the output signal of the comparator 53.

On the other hand, the peak-hold circuit 54 is composed of a resistor having one end to which the reference voltage Vr is applied, and a capacitor having one end connected to the other end of the above-mentioned resistor, wherein a detection voltage Vd is outputted from a connection node or junction between the resistor and the capacitor.

In the case of the high-side type motor current detecting circuit shown in Fig. 11, a shunt voltage V1 making appearance across the shunt resistor Rs is amplified by the differential amplifier 51 incorporated in the motor current detecting circuit 50.

Further, a high-side type voltage of the shunt resistor Rs (i.e., voltage at the end of the shunt resistor Rs of high potential) is applied to a half-wave rectifier constituted by the differential amplifier 52 and the comparator 53.

Owing to the arrangement described above, the amplified voltage outputted from the differential amplifier 51 undergoes a level shift corresponding to a difference from the reference voltage Vr to be held by the peak-hold circuit 54. The output of the peak-hold circuit 54 thus represents the detection voltage Vd of the motor current detecting circuit 50.

With the circuit configuration of the high-side type motor current detecting circuit in which the shunt resistor Rs is employed, as described above, it is possible to detect also a ground-fault of a power supply conductor or wire leading to the electric motor M, whereby there can be implemented the motor current detecting circuit which can enjoy excellent fail-safe feature when compared with a so-called low-side type motor current detecting circuit in which the shunt resistor Rs is installed at the ground side (not shown), as is pointed out in JP-A-4-251596 as well.

However, in the case of the high-side type motor current detecting circuit in which the shunt resistor Rs is installed at the side of the battery 9 (i.e., at the high potential side or at the high side, for short) which constitutes the main power-supply circuit, there exists a problem that the detection signal outputted from the high-side type motor current detecting circuit is susceptible to influence of variations of the shunt voltage due to intervention of wiring impedance of the battery 9 (described later on) upon electric energization of the motor M, even when the battery voltage supplied from the battery 9 remains stable.

Accordingly, with the circuit arrangement in which both ends of the shunt resistor Rs are directly connected to the input terminals of the differential amplifier 51 (amplifier circuit), an amplification error (hereinafter referred to also as the detection error) is likely to occur due to variation in the voltage applied across the input terminals of the differential amplifier (amplifier circuit) 51.

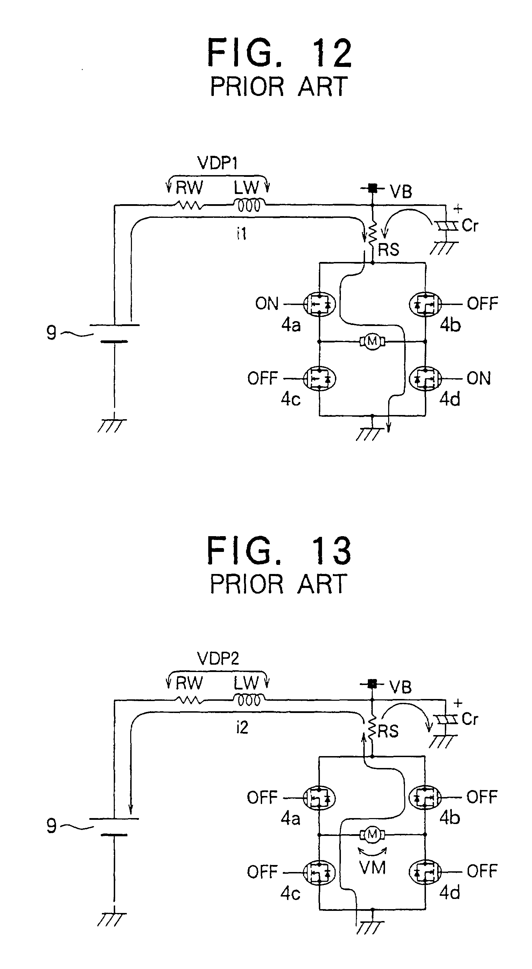

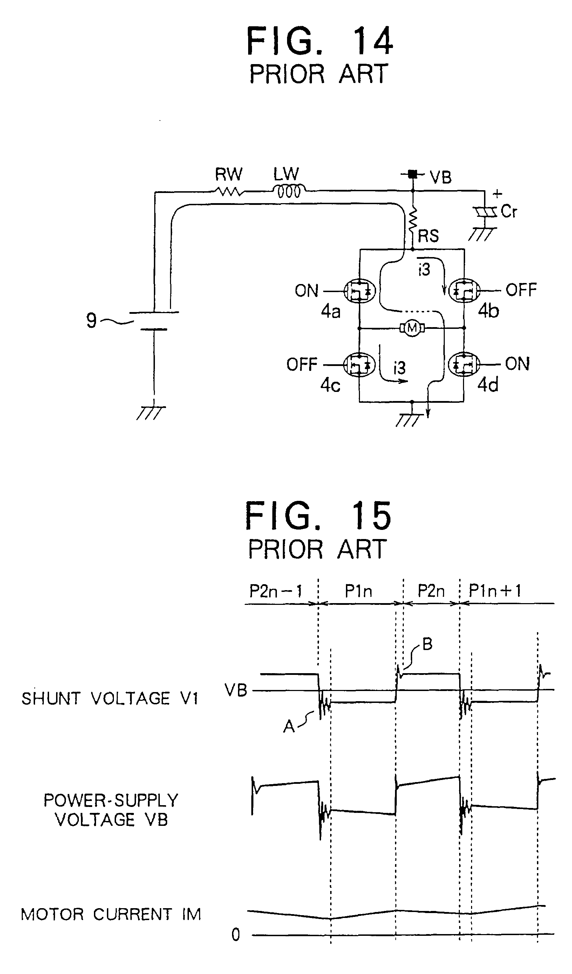

Now, referring to schematic circuit diagrams shown in Figs. 12 to 14 together with a waveform diagram shown in Fig. 15, description will briefly be made of factors or causes which involve variations in the input voltage for the conventional high-side type motor current detecting circuit shown in Fig. 11 as well as detection error in the output of the conventional high-side type motor current detecting circuit.

Figures 12 to 14 are equivalent circuit diagrams for illustrating current paths along which the motor current flows upon electric energization of the motor M in the state where all the FETs 4a, 4d; 4b, 4c of the H-bridge circuit 4 are driven in the PWM switching mode, and Fig. 15 is a waveform diagram showing the shunt voltage V1 making across the shunt resistor Rs, a power-supply voltage VB and a motor current IM.

At this juncture, it should be noted that the power-supply voltage VB represents an input terminal voltage for the motor control circuit which contains voltage variation components because the power-supply voltage VB is applied from the battery 9 (main power-supply circuit) through wiring impedance presented by the ignition switch 8 and others.

Referring to Figs. 12 to 14, a ripple capacitor Cr (provided ordinarily for removing ripple components although not shown in Figs. 10 and 11) is connected in parallel with the battery 9 for suppressing variations or fluctuations of the power-supply voltage VB, wherein the ripple capacitor Cr constitutes the main power-supply circuit together with the battery 9. The main power-supply circuit supplies the motor current IM for driving the motor M by way of the H-bridge circuit 4.

Further, the power-supply voltage VB applied to the H-bridge circuit 4 via a path (containing a wiring resistance component RW and a wiring inductance component LW) from the battery 9 is applied to one end of the shunt resistor Rs.

Referring to Fig. 12, a path indicated by an arrow i1 represents a current flow path along which the current flows from the battery 9 when the FETs 4a and 4d constituting a part of the H-bridge circuit 4 are turned on.

In that case, because the wiring resistance component RW (having a resistance value R) and the L-component LW (having an inductance value L) exist in the current path, there is produced a voltage drop VDP1 which is given by the following expression.

$$VDP1 = R \cdot i1 + L \cdot dt / di1$$

In Fig. 13, an arrow i2 extending from the ground potential indicates a current path along which the motor current flows when the FETs 4b and 4c are turned on with the FETs 4a and 4d being turned off, starting from the state shown in Fig. 12.

Referring to Fig. 13, when a regenerative voltage VM is generated by the electric motor M, a regenerative current i2 flows to the battery 9 (main power-supply circuit) via parasitic diodes incorporated in the FETs 4b and 4c (i.e., via diode components formed between drains and sources of the FETs 4b and 4c, respectively). In that case, a voltage drop PVD2 makes appearance due to the regenerative current i2.

For the reason described above, the power-supply voltage VB undergoes variation upon every power supply to the motor M due to the presence of the wiring resistance component RW and inductance component LW (i.e., due to the presence of the wiring impedance).

Under the circumstances, there has heretofore been provided a ripple capacitor Cr in association with the main power-supply circuit as an attempt to suppress the variation of the power-supply voltage VB. Owing to such measures, variation of the power-supply voltage VB can certainly be suppressed more or less.

However, because of the presence of impedance internally of the ripple capacitor Cr as well, variation of the power-supply voltage VB is necessarily induced in synchronism with the switching operation of the FET 4a, 4d; 4b, 4c upon power supply to the motor M by driving the FETs with PWM drive pulses.

Next, referring to Fig. 14, description will turn to behavior of the high-side type motor current detecting circuit at the moment when the FETs 4a and 4d are switched from the off-state (nonconducting state) to the on-state (conducting state).

As can be seen from Fig. 14, immediately after the FETs 4a and 4d was turned on, the parasitic diodes of the FETs 4b and 4c are broken down to allow a through-current (suddenly increased current also referred to as breakdown current) i3 to flow momentarily through the FETs 4b and 4c.

In this conjunction, it is noted that the through-current i3 assumes an extremely large peak value because of flowing along the current path exhibiting a very low ohmic resistance. Besides, due to the presence of the shunt resistor Rs and inductance (L-component) presented by the H-bridge circuit 4, the through-current i3 gives rise to generation of high-frequency switching noise (refer to Fig. 15 at A).

The through-current i3 disappears after lapse of the restoration time of the parasitic diodes mentioned above.

On the other hand, at the moment the FETs 4b and 4c are switched from the on-state to the off-state (not illustrated), the current path changes over from the state illustrated in Fig. 13 to the state illustrated in Fig. 12. As a result of this, switching noise will equally be generated due to the wiring impedance LW (refer to Fig. 15 at B).

It goes without saying that when the power supply to the motor M is effected through PWM-driving of the FETs 4a;4d, 4b;4c constituting the H-bridge circuit 4, the operation modes described above are repetitively executed, which results in that the power-supply voltage VB undergoes such variations as illustrated in Fig. 15.

Referring to Fig. 15, it can be seen that the power-supply voltage VB is superposed with the high-frequency noise components originating in the recovery current which flows through the parasitic diodes formed internally of each FET when the FETs 4a, 4d, 4b, 4c are switched from the off-state to the on-state in addition to the voltage change which makes appearance in synchronism with the PWM pulses RP and LP due to the conducting current and the regenerative current i2 of the electric motor M.

At this juncture, it should be recalled that in the high-side type motor current detecting circuit, the shunt resistor Rs is disposed between the H-bridge circuit 4 and the input terminal (connected to the battery 9) at which the power-supply voltage VB is susceptible to variations. Accordingly, the shunt voltage V1 making appearance across the shunt resistor Rs is necessarily subjected to the influence of the variations of the power-supply voltage VB.

Consequently, when the shunt voltage V1 appearing across the shunt resistor Rs is inputted directly to the differential amplifier 51 as shown in Figs. 10 and 11, detection error will be brought about when the AC component of the shunt voltage V1 increases to or beyond a saturation level of the differential amplifier 51.

On the other hand, when the output of the main power-supply circuit and the ground potential of the H-bridge circuit 4 are employed as the inputs for the differential amplifier 51, variations of the voltage supplied from the main power-supply circuit make appearance as common-mode noises of the differential amplifier 51, providing a cause for amplification error.

As the measures for coping with the problems mentioned above, it has already been proposed to provide a waveform shaping circuit 55 and a DC smoothing circuit 56 at the output side of the differential amplifier 51 (see Fig. 10) in an effort to eliminate or suppress the influence of variation of the power-supply voltage VB brought about upon turning of the FETs 4a, 4d; 4b, 4c to thereby prevent or suppress the detection error, as is disclosed, for example, in Japanese Unexamined Patent Application Publication No. 80860/1996 (JP-A-8-80860).

The measures mentioned above are certainly effective so far as the variation of the power-supply voltage VB remains small. However, because the switching noise in the normal mode as well as the common-mode noise brought about by variation of the power-supply voltage VB are inputted directly to the differential amplifier 51, it is impossible to prevent or suppress satisfactorily the detection error when variation of the power-supply voltage VB increases to the saturated operation level of the differential amplifier 51.

Furthermore, in the case of the high-side type motor current detecting circuit disclosed in Japanese Unexamined Patent Application Publication No. 251596/1992 (JP-A-4-251496)(see Fig. 11), no measures are taken to cope with the detection error even though the shunt resistor Rs is directly coupled to the differential amplifier 51.

Besides, in conjunction with the high-side type motor current detecting circuit shown in Fig. 11, it is noted that the amplifier circuit is constituted by the three differential amplifiers (inclusive of comparator) 51 to 53. Accordingly, three offset voltages of these differential amplifiers 51 to 53 are combined accumulatively. Thus, there exists high possibility of error being involved in the detection output of the motor current detecting circuit 50 due to nonuniformity of the offset voltages in addition to the detection error due to the variation in the power-supply voltage VB.

Moreover, in the motor current detecting circuit 50 shown in Fig. 11, the detection voltage Vd outputted when the value of the motor current IM is 0 A (zero ampere) is the reference voltage Vr itself. Accordingly, absolute accuracy (i.e., accuracy in the absolute sense) is required for generation of the reference voltage Vr.

Thus, unless the absolute accuracy can be ensured for the reference voltage Vr, the central processing unit or CPU (not shown) incorporated in the controller has to be so programmed as to learn the detection voltage Vd outputted from the motor current detecting circuit 50 when the motor current IM becomes zero ampere by providing an appropriate correcting means in association with controller.

In general, as the measures for suppressing the detection error, there may be conceived two measures (1) and (2) mentioned below.

(1) Optimization of the circuit structure or configuration of a large-current circuit section including the H-bridge circuit 4, the shunt resistor Rs and the ripple capacitor Cr (hereinafter this circuit section will be referred to as power circuit section).
(2) Implementation of the differential amplifier 51 constituting a part of the amplifier circuit by using a high-speed differential amplifier excellent in respect to the high-frequency characteristics such as through-rate, variation eliminating capability and others.

The measures (1) mentioned above can be realized by decreasing the inductance component LW by shortening the wiring length, installing a snubber circuit, adopting soft-switching scheme and/or using a ripple capacitor Cr of a large capacity (of low impedance) for suppressing the variation of the power-supply voltage VB which occurs in synchronism with the PWM signals RP and LP. On the other hand, the measures (2) can be realized by improving the frequency-response performance or characteristic of the amplifier circuit (differential amplifier 51).

However, the measures (1) mentioned above involve large overhead in designing for practical application because of the necessity for a large size component such as the ripple capacitor Cr of large capacity, disposition and wiring thereof for optimization and encounters a limitation in implementation of the motor control apparatus in a miniaturized size as demanded commercially in these years.

On the other hand, improvement of the frequency response of the amplifier circuit proposed as the measures (2) requires a high-speed and expensive element as the differential amplifier 51, incurring a problem that the manufacturing cost of the high-side type motor current detecting circuit increases.

As is apparent from the foregoing description, in the case of the conventional high-side type motor current detecting circuit known heretofore in which the shunt voltage V1 produced across the shunt resistor Rs is inputted straightforwardly or directly to the differential amplifier 51, the detection voltage Vd outputted finally or ultimately suffers error (i.e., detection error) because the shunt voltage V1 is affected by variations of the power-supply voltage VB. Besides, similar detection error is brought about when the AC component of the shunt voltage V1 increases to the saturated level beyond the high-speed response capability of the differential amplifier 51. Thus, it is safe to say that the conventional high-side type motor current detecting circuit suffers a problem that the motor current IM can not be detected satisfactorily with high accuracy and reliability.

More specifically, in the case of the high-side type motor current detecting circuit disclosed in Japanese Unexamined Patent Application Publication No. 251596/1992 (JP-A-4-251596)(see Fig. 11), no measures are adopted for dealing with the detection error notwithstanding of the fact that both ends of the shunt resistor Rs are directly connected to the inputs of the differential amplifier 51. Thus, this high-side type motor current detecting circuit suffers from a problem that the accuracy in detecting the motor current IM is degraded.

Similarly, in the case of the high-side type motor current detecting circuit in which the waveform shaping circuit 55 and the DC smoothing circuit 56 are provided at the output side of the differential amplifier 51 for mitigating the influence of variations in the power-supply voltage VB which occurs upon switching-off of the FET 4a, 4d; 4b, 4c, as described in Japanese Unexamined Patent Application Publication No. 80860/1996 (JP-A-8-80860)(see Fig. 10), there is a problem that the detection error can not be suppressed when the variation of the power-supply voltage VB reaches the saturation level of the differential amplifier 51 because neither the switching noise inputted to the differential amplifier 51 in the normal mode of operation nor the common mode noise brought about by variation of the power-supply voltage VB can not be reduced directly or straightforwardly.

Furthermore, in both the conventional motor current detecting circuits shown in Figs. 10 and 11 in which the main power-supply circuit including the battery 9 is employed as the power supply source for the differential amplifier 51 with the ground for the H-bridge circuit 4 being used as that for the differential amplifier 51, variation of the power-supply voltage VB makes appearance as the common mode noise in the output of the differential amplifier 51, providing a cause for the amplification error.

Additionally, approach for optimizing the power circuit section comprised of the H-bridge circuit 4, the shunt resistor Rs and the ripple capacitor Cr involves high manufacturing cost or overhead because of the necessity for components of large sizes or dimensions such as the ripple capacitor Cr of a large capacity. Besides, great difficulty will be encountered in the attempt for realization in a miniaturized structure. Of course, use of a high-speed differential amplifier exhibiting excellent high-frequency characteristics as the differential amplifier 51 will be accompanied with high expensiveness.

EP 0 393 847 A1 describes an inductive load control with current simulation including a micro computer controlling current supply to an inductive load from a power source. The inductive load may, for example, be a motor connected to an H-bridge driver containing power MOSFETs respectively for individually switching the arms of the bridge to apply current to the electric motor. The circuit also includes resistors chosen to develop a voltage equal to a level shift voltage providing the control apparatus with the capability to more accurately control the current through the inductive load. During operation a capacitor is charged to a voltage for simulating an applied current when the applied current is terminated. An induced current flows through the inductive load after the termination and decays at a rate determined by the load. The current to the load is controlled by comparing the simulated value to the command value and applying and terminating current to maintain the simulated value close to a command value.

US 4,494,181 describes a circuit arrangement for determining the polarity and magnitude of the load current in a reversible D-C-controller or chopper including a current transformer having two primary windings as measuring sensors, wherein each primary winding is connected to the opposite winding sense into diagonal bridge arms of four bridge arms of a bridge circuit. The bridge circuit includes electronic switches which may be constituted by transistors.

SUMMARY OF THE INVENTION

In the light of the state of the art described above, it is an object of the present invention to provide a high-side type motor current detecting circuit for detecting a current flowing through an electric motor employed, for example, in a motor-driven power steering system of a motor vehicle, which circuit can detect the motor current with high accuracy and reliability with a simplified and inexpensive structure and which can amplify a voltage signal appearing across a shunt resistor with high accuracy and fidelity.

In view of the above and other objects which will become apparent as the description proceeds, there is provided according to a general aspect of the present invention a high-side type motor current detecting circuit which includes a plurality of FETs (field-effect transistor) constituting an H-bridge circuit, an electric motor connected to the H-bridge circuit, a control means for commanding a direction of a current flow through the electric motor and magnitude of the current flow, an FET driving circuit for driving the FETs with PWM (pulse-width modulated) signals in accordance with a command signal issued by the control means, a main power-supply circuit for supplying a motor current to the H-bridge circuit for driving the electric motor, a shunt resistor inserted between the H-bridge circuit and the main power-supply circuit, a sample-and-hold circuit including an analogue switch for sampling a voltage detected across the shunt resistor when the FETs are tuned on in synchronism with the command signal, wherein the sample-and-hold circuit holds the voltage when the FETs are turned off, an amplifier circuit including a differential amplifier for amplifying the voltage held by the sample-and-hold circuit, for thereby supplying a detection voltage corresponding to the motor current to the control means, a negative voltage power-supply circuit provided between the sample-and-hold circuit and the amplifier circuit for generating a first ground level for the amplifier circuit, and a switch driving signal generating circuit for generating a switch driving signal for turning on/off the analogue switch in synchronism with the command signal. The amplifier circuit includes a constant-current circuit for shifting a voltage level of the detection voltage to a given ground level, while the first ground level is isolated from a second ground level for other circuits than the differential amplifier and given by a negative constant voltage with reference to a power-supply voltage of the main power-supply circuit, whereby amplification error involved in amplification of the detection voltage signal as brought about by variation of the voltage of the main power-supply circuit upon flowing of the motor current through the electric motor is suppressed.

With the structure of the high-side type motor current detecting circuit described above, the power-supply voltage and the ground level for the differential amplifier incorporated in the amplifier circuit can be stabilized relative to the reference potential provided by the main power-supply circuit. Further, by sampling once the voltage appearing across the shunt resistor by means of the sample-and-hold circuit to convert the sampled voltage into a DC voltage, the power supply voltage and the input voltage for the differential amplifier incorporated in the current detecting circuit can be regarded essentially as DC voltages. Thus, the high-side type motor current detecting circuit can operate without dependency on the input circuit configuration and the through-rate of the differential amplifier and the AC characteristics such as elimination ratio of variation in the power-supply voltage. Owing to this feature, the voltage detected from the shunt resistor can be amplified with enhanced accuracy, whereby the high-side type motor current detecting circuit which can ensure high reliability for the motor current detection is realized inexpensively, to a great advantage.

In a preferred mode for carrying out the invention, the differential amplifier may include an NPN-transistor input circuit, while the negative voltage power-supply circuit may include a capacitor inserted between the main power-supply circuit and the second ground level, a Zener diode connected in parallel with the capacitor and having a cathode terminal connected to the main power-supply circuit, and a resistor connected in series to an anode terminal of the Zener diode, wherein the first ground level is generated from the anode terminal of the Zener diode.

With the arrangement of the high-side type motor current detecting circuit described above, the voltage detected from the shunt resistor can be amplified with high accuracy with a simplified circuit configuration.

In another preferred mode for realizing the invention, the differential amplifier may include a PNP-transistor input circuit, while the negative voltage power-supply circuit may include a positive constant-voltage power supply and a negative constant-voltage power supply for generating positive and negative constant voltages having positive and negative polarities, respectively, with reference to the power-supply voltage of the main power-supply circuit.

By connecting the positive constant-voltage power supply as the power supply to the differential amplifier while employing the negative constant-voltage power supply as the ground level for the differential amplifier, the power supply voltage as well as the ground level for the differential amplifier incorporated in the amplifier circuit can be stabilized relative to the main power-supply circuit. Owing to this feature, the voltage detected from the shunt resistor can be amplified with high accuracy, whereby there can be realized at a low cost a high-side type motor current detecting circuit which can ensure high reliability for the motor current detection.

In yet another preferred mode for carrying out the invention, the switch driving signal generating circuit may be so designed as to include a delay circuit for setting different delay times, respectively, for rising and falling of the switch driving signal.

By virtue of the arrangement described above, the switching noise components can be eliminated from the signal representing the voltage appearing across the shunt resistor before the signal is inputted to the amplifier circuit because the timing for turning on the analogue switch upon sampling of the voltage appearing across the shunt resistor is delayed by the delay circuit. Owing to this feature, the voltage detected from the shunt resistor can be amplified with enhanced accuracy. Thus, there can be realized inexpensively a high-side type motor current detecting circuit which can ensure high reliability for the motor current detection.

In a further preferred mode for carrying out the invention, the constant-current circuit may be so arranged as to include a level-shift dedicated PNP-transistor provided at the output side of the amplifier circuit and having a base connected to the output terminal of the differential amplifier, a first resistor inserted between an inverting input terminal of the differential amplifier and the main power-supply circuit, a second resistor inserted between the inverting input terminal of the differential amplifier and an emitter terminal of the level-shift dedicated PNP-transistor, a third resistor inserted between the main power-supply circuit and the emitter terminal of the level-shift dedicated PNP-transistor, and a fourth resistor inserted between a collector terminal of the level-shift dedicated PNP-transistor and the second ground level, wherein a first gain of the amplifier circuit is determined by the first and second resistors, while a second gain of the amplifier circuit is determined by the third and fourth resistors.

Owing to this feature, the voltage detected from the shunt resistor can be amplified with enhanced accuracy, whereby the high-side type motor current detecting circuit which can ensure high reliability for the motor current detection can be realized inexpensively, to a great advantage.

In a yet further preferred mode for carrying out the invention, the motor current detecting circuit may be implemented in the form of a monolithic integrated circuit, wherein the first and second ground levels should be preferably isolated from each other internally of the monolithic integrated circuit.

Owing to this feature, the voltage detected from the shunt resistor can be amplified with enhanced accuracy, whereby the high-side type motor current detecting circuit which can ensure high reliability for the motor current detection is realized inexpensively, to a great advantage.

In a still further preferred mode for carrying out the invention, the amplifier circuit may be implemented in the form of a monolithic integrated circuit, wherein the monolithic integrated circuit may include the differential amplifier, the first and second resistors, the level-shift dedicated PNP-transistor, a first terminal to which a power supply voltage is applied from the main power-supply circuit as a reference voltage for the amplifier circuit, and a second terminal to which one end of the third resistor is connected, the third resister having the other end connected to the first terminal, wherein the first and second terminals are disposed closely to each other, while the third resistor is disposed externally of the monolithic integrated circuit.

By connecting the third resistor between the first and second terminals disposed adjacent to each other (in the vicinity of the main power-supply circuit), the phase difference in AC component between the reference voltage for the amplifier circuit and the reference voltage applied to the third resistor can be reduced, which contributes to suppression of the detection error. Owing to this feature, the voltage detected from the shunt resistor can be amplified with enhanced accuracy, whereby the high-side type motor current detecting circuit which can ensure high reliability for the motor current detection can be realized inexpensively, to another advantage.

Further, according to the high-side type motor current detecting circuit mentioned above, resistors may be connected in series to input terminals of the differential amplifier, respectively.

By constituting the integrating circuit by the resistors mentioned above together with the parasitic input capacitance of the input transistor constituting a part of the differential amplifier, the AC component inputted to the amplifier circuit can be reduced owing to the integrating operation. More specifically, even the high-frequency switching noise components which are contained in the AC components inputted to the differential amplifier and which can not be eliminated by the sample-and-hold circuit can further be attenuated, whereby the high-side type motor current detecting circuit can be imparted with the facility for preventing the differential amplifier from being saturated.

The above and other objects, features and attendant advantages of the present invention will more easily be understood by reading the following description of the preferred embodiments thereof taken, only by way of example, in conjunction with the accompanying drawings.

BRIEF DESCRIPTION OF THE DRAWINGS

In the course of the description which follows, reference is made to the drawings, in which:

Fig. 1 is a block diagram showing a high-side type motor current detecting circuit according to a first embodiment of the present invention;
Fig. 2 is a diagram showing in concrete an exemplary circuit configuration of a differential amplifier employed in the high-side type motor current detecting circuit shown in Fig. 1;
Fig. 3 is a circuit diagram showing in concrete exemplary circuit configurations of a gate circuit and a delay circuit both shown in Fig. 1 together with peripheral circuitries;
Fig. 4 is a waveform diagram showing waveforms of various signals generated in the motor current detecting circuit shown in Fig. 1 for illustrating operations of an FET driving circuit and a sample-and-hold circuit;
Fig. 5 is a waveform diagram showing various voltage signals generated in the high-side type motor current detecting circuit shown in Fig. 1 for illustrating motor current detecting operation thereof;
Fig. 6 is a diagram showing circuit configurations of a negative voltage power-supply circuit and a differential amplifier according to a second embodiment of the invention;
Fig. 7 is a block diagram showing a configuration of the high-side type motor current detecting circuit according to a third embodiment of the invention which is suited for implementation as a monolithic IC;
Fig. 8 is a top plan view showing fragmentarily an outer appearance of a high-side type motor current detecting circuit according to a fourth embodiment of the present invention with some parts shown in section;
Fig. 9 is a plan view showing partially in section an exemplary package for comparison with the monolithic IC structure shown in Fig. 8;
Fig. 10 is a circuit diagram showing a circuit configuration of a conventional motor driven power steering system of a motor vehicle;
Fig. 11 is a circuit diagram showing a conventional motor current detecting circuit employed in the motor driven power steering system known heretofore;
Fig. 12 is an equivalent circuit diagram for illustrating a current flow path in an H-bridge circuit when relevant FETs of the H-bridge circuit are turned on;
Fig. 13 is an equivalent circuit diagram for illustrating a current flow path in an H-bridge circuit when relevant FETs of the H-bridge circuit are turned off;
Fig. 14 is a diagram for illustrating current paths along which currents flow at the moment when the relevant FETs are switched from the off-state to the on-state; and
Fig. 15 is a waveform diagram for illustrating operation of the conventional high-side type motor current detecting circuit.

DESCRIPTION OF THE PREFERRED EMBODIMENTS

Now, the present invention will be described in detail in conjunction with what is presently considered as preferred or typical embodiments thereof by reference to the drawings. In the following description, like reference characters designate like or corresponding parts throughout the several views. Also in the following description, it is to be understood that such terms as "clockwise", "counterclockwise", "negative", "positive" and the like are words of convenience and are not to be construed as limiting terms.

Embodiment 1

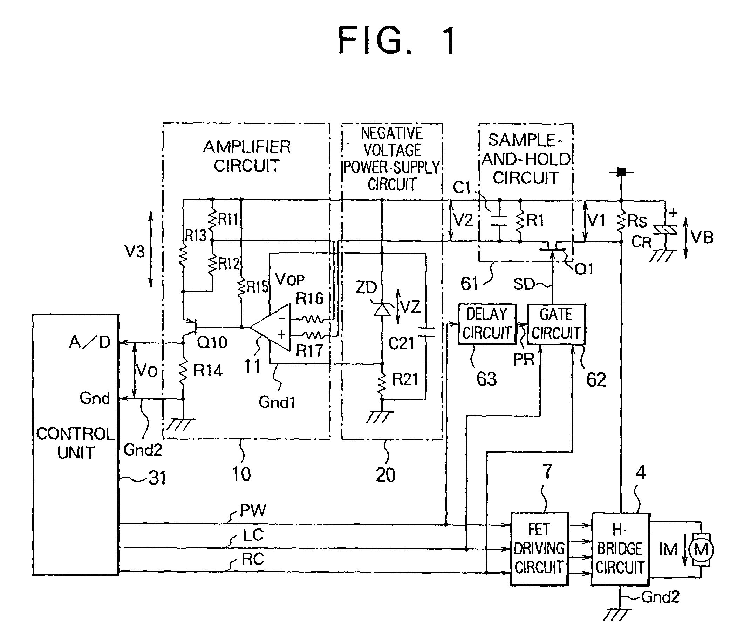

A first embodiment of the present invention will be described. Figure 1 is a block diagram showing a high-side type motor current detecting circuit according to a first embodiment of the invention. In the figure, components same as or equivalent to those described hereinbefore are denoted by like reference characters and repeated description thereof is omitted. Parenthetically, the relay 6, the ignition switch 8 and the battery 9 (see Fig. 10) are omitted from illustration for simplification of the drawing. Further, it should be added that the circuit configuration and operation of the H-bridge circuit 4 are essentially same as described hereinbefore by reference to Fig. 10 and Figs. 12 to 14.

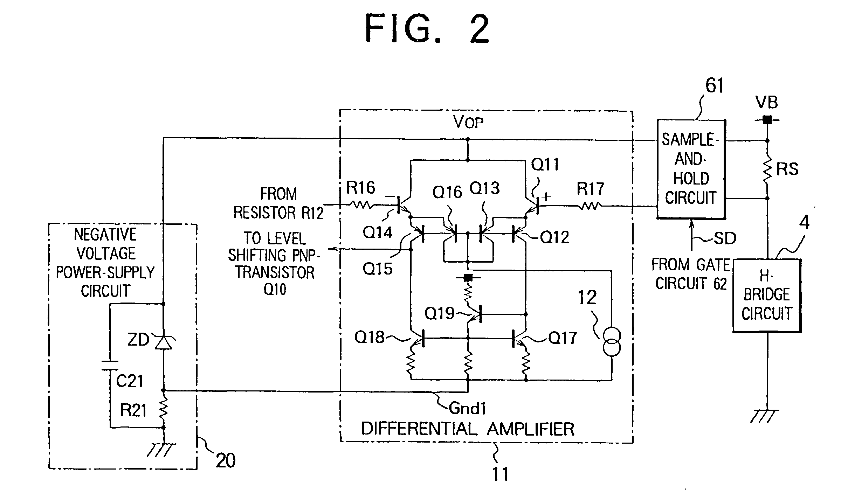

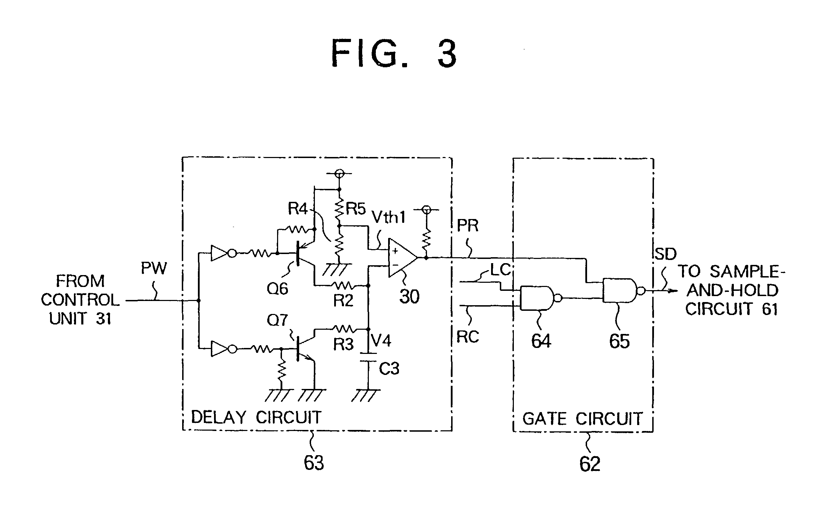

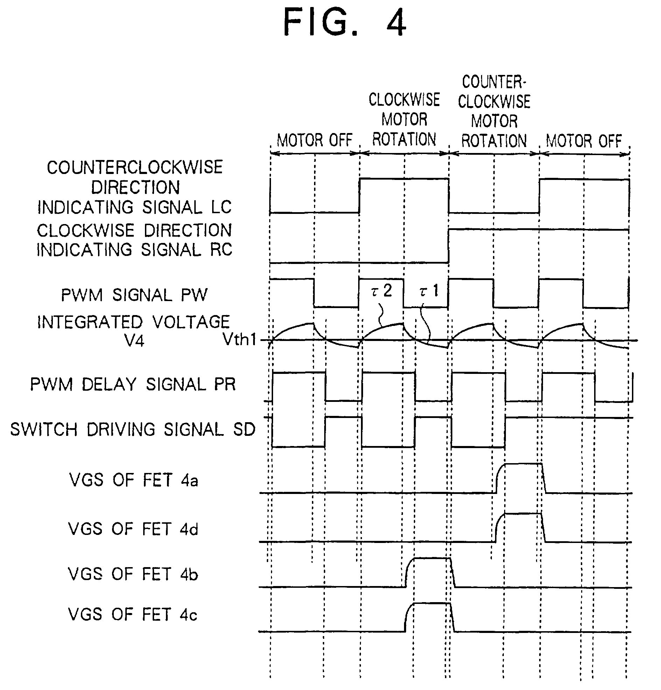

Figure 2 is a circuit diagram showing in concrete a circuit configuration of a differential amplifier 11 of the high-side type motor current detecting circuit shown in Fig. 1, Fig. 3 is a circuit diagram showing in concrete structures of a gate circuit 62 and a delay circuit 63 both shown in Fig. 1, and Fig. 4 is a waveform diagram showing waveforms of various signals appearing in the circuit shown in Fig. 1 and illustrating operations of the FETs 4a, 4b, 4c, 4d (see Fig. 10) incorporated in the H-bridge circuit 4, respectively.

Referring to Fig. 1, a motor control circuit is comprised of a shunt resistor Rs, an H-bridge circuit 4, an FET driving circuit 7, an amplifier circuit 10, a negative voltage power-supply circuit 20, a sample-and-hold circuit 61, a gate circuit 62, a delay circuit 63 and a control unit 31.

The control unit 31 which may be constituted by a microcomputer is so designed or programmed that a motor current IM corresponding to a desired or target value such as a target motor torque detected by a target value detecting unit (not shown) can flow through the electric motor M under the control of the control unit 31. To this end, the control unit 31 issues a pulse-width modulated or PWM signal PW indicative of a current flow for energization of the motor M and a counterclockwise (forward) direction command signal LC or a clockwise (reverse) direction command signal RC for commanding the direction in which the motor M is to rotate.

The FET driving circuit 7 is implemented in a same structure as that described hereinbefore by reference to Fig. 10 and composed of NOR gates and inverters equivalent to those denoted by 7a; 7b and 7c; 7d in Fig. 10. The FET driving circuit 7 serves for driving the FETs 4a, 4d; 4b, 4c of the H-bridge circuit 4 with PWM pulse signals in conformance with the PWM signal PW and the counterclockwise direction command signal LC or the clockwise direction command signal RC issued by the control unit 31. More specifically, the FET driving circuit 7 drives a set of FETs (i.e., FETs 4a and 4d or FETs 4b and 4c) which corresponds to the rotational direction of the motor M commanded by the counterclockwise direction command signal LC or the clockwise direction command signal RC in synchronism with the PWM signal PW, as can be seen from the waveforms illustrated in Fig. 4.

In general, an N-channel FET is employed as the FET constituting the H-bridge circuit 4 from the standpoint of the manufacturing cost and the commercial availability (see Fig. 10). In that case, a booster circuit such as a bootstrap circuit is required for driving the FETs 4a and 4b inserted in the upper arms of the H-bridge circuit 4 as viewed in Fig. 10.

In this conjunction, it is assumed that the function equivalent to that of the booster circuit is incorporated in the FET driving circuit 7 although illustration thereof is omitted in Fig. 1.

Furthermore, the paths along which the current flows during operation of the H-bridge circuit 4 are same as those described hereinbefore by reference to Figs. 12 to 14. Accordingly, repeated description thereof will be unnecessary.

The motor current IM flowing through the motor M in conformance with the PWM signal PW and the counterclockwise direction command signal LC or the clockwise direction command signal RC issued from the control unit 31 is converted into a voltage V1 by means of the shunt resistor Rs provided at the high side of the H-bridge circuit 4. This voltage V1 represents in reality a voltage drop appearing across the shunt resistor Rs due to the motor current IM and is referred to as the shunt voltage for the convenience of description.

The shunt voltage V1 appearing across the shunt resistor Rs is applied to the sample-and-hold circuit 61 which is composed of an analogue switch Q1 connected to a junction between the shunt resistor Rs and the H-bridge circuit 4, a resistor R1 connected in parallel with the shunt resistor Rs by way of the analogue switch Q1 and a capacitor Cl connected in parallel with the resistor R1. In this conjunction, it will be noted that the resistor R1 and the capacitor Cl cooperate to constitute a time constant circuit.

The sample-and-hold circuit 61 serves to sample and store in the capacitor Cl the shunt voltage V1 appearing across the shunt resistor Rs during the period in which the relevant FETs (4a and 4d or 4b and 4c) of the H-bridge circuit 4 are in the on-state set in response to the switch-on operation of the analogue switch Q1 in synchronism with the command signals PW and LC or RC, while in the off-state of the relevant FETs, the voltage appearing across the capacitor Cl is outputted as a hold voltage V2 in response to the switch-off operation of the analogue switch Q1.

The sample-and-hold circuit 61 is so controlled that the shunt voltage V1 is sampled immediately after the relevant FETs (4a, 4d or 4b, 4c) was turned on with the switching noise being eliminated and that the shunt voltage V1 is held at a time point immediately before the FETs are turned off.

To this end, there is provided a switch driving signal generating circuit which is designed for generating a switch driving signal SD for switching the analogue switch Q1 and which is comprised of a gate circuit 62 for generating the switch driving signal SD on the basis of a PWM delay signal PR and a delay circuit 63 for generating the PWM delay signal PR by delaying the PWM signal PW.

More specifically, the delay circuit 63 incorporated in the switch driving signal generating circuit serves to set different delay times for the rising edge and the falling edge of the switch driving signal SD, respectively.

On the other hand, the gate circuit 62 generates the switch driving signal SD on the basis of the counterclockwise direction command signal LC or the clockwise direction command signal RC for thereby turning on/off the analogue switch Q1 in timing with the counterclockwise direction command signal LC or the clockwise direction command signal RC.

A negative voltage power-supply circuit 20 designed for serving as a stable power supply for driving the amplifier circuit 10 is provided between a power-supply voltage terminal of a main power-supply circuit composed of the battery 9 (see Fig. 10) and a ripple capacitor Cr and a second ground level Gnd2, for applying to a differential amplifier 11 incorporated in the amplifier circuit 10 a first ground level Gnd1 set with reference to the power-supply voltage VB supplied to the motor control circuit.

The negative voltage power-supply circuit 20 is composed of a decoupling capacitor C21 inserted between the terminal (for the power-supply voltage VB) of the main power-supply circuit and the second ground level Gnd2, a Zener diode ZD connected in parallel with the decoupling capacitor C21 and having a cathode connected to the power-supply voltage terminal (VB), and a resistor R21 connected in series to an anode of the Zener diode ZD, wherein the first ground level Gnd1 is outputted from the anode terminal of the Zener diode ZD.

The Zener diode ZD and the resistor R21 constituting the negative voltage power-supply circuit 20 serve for holding a voltage difference between a driving voltage Vop (power-supply voltage VB) and the first ground level Gnd1 as a constant and stable voltage.

The amplifier circuit 10 includes a differential amplifier 11 realized, for example, in the form of an NPN-transistor input circuit and a constant-current circuit (described hereinafter) for shifting the level of a detection voltage Vo to a given ground level (i.e., to a second ground level Gnd2 in the case of the instant embodiment of the invention), wherein the hold voltage V2 is amplified by the amplifier circuit 10 to thereby output the detection voltage Vo corresponding to the motor current IM to the control unit 31.

The differential amplifier 11 incorporated in the amplifier circuit 10 is applied with the power-supply voltage VB as the driving voltage Vop together with the first ground level Gndl to amplify the hold voltage V2.

Connected in series to the inverting input terminal (-) and the non-inverting input terminal (+) are serial resistors R16 and R17, respectively.

The serial resistor R16 connected to the inverting input terminal (-) of the differential amplifier 11 has the other end connected to a junction between resistors R11 and R12 of the constant-current circuit. On the other hand, the other end of the serial resistor R17 connected to the non-inverting input terminal (+) of the differential amplifier 11 is connected to the output terminal of the analogue switch Q1.

Additionally, a pull-up resistor R15 is inserted between the output terminal of the differential amplifier 11 and the power-supply voltage terminal.

Further, the first ground level Gnd1 for the differential amplifier 11 is separated or isolated from the second ground level Gnd2 for the other circuits than the differential amplifier 11 and assumes a constant voltage having negative polarity relative to the main power-supply circuit.

By virtue of the arrangement described above, it is possible to suppress error involved in the amplification (i.e., amplification error) of the detection voltage Vo which may otherwise be brought about due to voltage variation of the main power-supply circuit in the conducting state of the electric motor M.

On the other hand, the constant-current circuit disposed at the output side of the amplifier circuit 10 is comprised of a level shifting PNP-transistor Q10, resistors R11 and R12 connected in parallel with the resistor R13, and a resistor R14 inserted between a collector terminal of the level shifting PNP-transistor Q10 and the second ground level Gnd2, wherein the voltage appearing across the resistor R14 is outputted as the detection voltage Vo to be supplied to the control unit 31.

Figure 2 is a circuit block diagram showing in concrete a circuit configuration of the differential amplifier 11 employed in the high-side type motor current detecting circuit shown in Fig. 1. At this juncture, it should be mentioned that in the circuit configuration shown in Fig. 2, the differential amplifier 11 is implemented in the form of an NPN-transistor input circuit. Accordingly, no booster power-supply circuit is required for the differential amplifier 11.

Referring to Fig. 2, the differential amplifier 11 is comprised of an NPN-transistor Q11 having a base terminal which serves as the non-inverting input terminal (+) of the differential amplifier 11, PNP-transistors Q12 and Q13 having respective emitters connected to the emitter of the NPN-transistor Q11, an NPN-transistor Q14 having a base terminal serving as the inverting input terminal (-) of the differential amplifier 11, and NPN-transistors Q15 and Q16 having respective emitters connected to that of the NPN-transistor Q14.

Additionally, the differential amplifier 11 includes an NPN-transistor Q17 having a collector connected to that of the PNP-transistor Q12, an NPN-transistor Q18 having a collector connected to that of the PNP-transistor Q15, and an NPN-transistor Q19 having an emitter connected to bases of the NPN-transistor Q17 and Q18.

Connected to the base of the NPN-transistor Q11 is the serial resistor R17, while the serial resistor R16 is connected to the base of the NPN-transistor Q14.

The power-supply voltage VB is applied to each of the collectors of the NPN-transistor Q11 and the PNP-transistor Q12 as the driving voltage Vop, while the first ground level Gnd1 supplied from the negative voltage power-supply circuit 20 via a resistor is applied to each of the emitters of the NPN-transistors Q17, Q18 and Q19, respectively.

Furthermore, the bases of the PNP-transistors Q13 and Q16 are short-circuited to the respective collectors of the PNP-transistors Q13 and Q16, wherein a constant-current source 12 is connected to the junction between the bases and the collectors. The constant-current source 12 has the other end to which the output terminal of the negative voltage power-supply circuit 20 and the emitter terminals of the NPN-transistors Q17, Q18 and Q19 are connected.

Figure 3 is a circuit diagram showing in concrete exemplary circuit configurations of the gate circuit 62 and the delay circuit 63 employed in the high-side type motor current detecting circuit shown in Fig. 1, and Fig. 4 is a waveform diagram for illustrating operations of the delay circuit 63 and the gate circuit 62.

Referring to Fig. 3, the gate circuit 62 is comprised of a NAND gate 64 for determining a logical product or logical ANDing the counterclockwise direction command signal LC and the clockwise direction command signal RC, and a NAND gate 65 for logically ANDing the output signal of the NAND gate 64 and the PWM delay signal PR to thereby output the switch driving signal SD for the analogue switch Q1 of the sample-and-hold circuit 61.

On the other hand, the delay circuit 63 is composed of a PNP-transistor Q6 and an NPN-transistor Q7 operating in response to the PWM signal PW, resistors R2 and R3 connected to the collector output terminals of the transistors Q6 and Q7, respectively, resistors R4 and R5 inserted between the power supply and the ground potential, a capacitor C3 inserted between the junction of the resistors R2 and R3 and the ground potential and a comparator 30 for outputting the PWM delay signal PR.

The emitter terminal of the PNP-transistor Q6 is connected to the power supply, while that of the NPN-transistor Q7 is grounded (i.e., connected to the ground potential).

The comparator 30 compares an integrated voltage V4 derived from one end of the capacitor C3 with a divided voltage Vth1 derived from a junction between the resistors R4 and R5 to thereby output the PWM delay signal PR. As a power supply source for generating the divided voltage Vth1 and the PWM delay signal PR, a stable power supply (e.g. of 5 volts) incorporated in the motor control circuit can be made use of.

Next, by reference to Fig. 4, description will be directed to operations of the switch driving signal generating circuit constituted by the delay circuit 63 and the gate circuit 62.

In the delay circuit 63, the PNP-transistor Q6 and the NPN-transistor Q7 are turned on in response to the PWM signal PW in a complementary manner, whereby the one end of the capacitor C3 is connected to the power supply by way of the associated resistor R2 or to the ground potential by way of the resistor R3, respectively.

The capacitor C3 charged/discharged upon every turn-on/off of the PNP-transistor Q6 and the NPN-transistor Q7 constitutes an integrating circuit together with the resistors R2 and R3, wherein the integrated voltage outputted from the one end of the capacitor C3 is applied to the non-inverting input terminal (+) of the comparator 30.

In this conjunction, it is to be noted that the path formed by the PNP-transistor Q6 and the resistor R2 for charging the capacitor C3 constituting a part of the integrating circuit is separated from the path formed by the NPN-transistor Q7 and the resistor R3 for discharging the capacitor C3. Accordingly, a time constant $\tau 2$ for the charging of the capacitor C3 (incurring rise-up of the integrated voltage V4) and a time constant $\tau 1$ for discharging the capacitor C3 (falling of the integrated voltage V4) can be set independent of each other, as can be seen from Fig. 4.

On the other hand, the divided voltage Vth1 obtained from voltage division by the resistors R4 and R5 is inputted to the inverting input terminal (-) of the comparator 30.

In response, the comparator 30 compares the divided voltage Vth1 with the threshold value to output the PWM delay signal PR which corresponds to the delayed integrated voltage V4 (see Fig. 4).

The gate circuit 62 in turn generates the switch driving signal SD for the sample-and-hold circuit 61 on the basis of the PWM delay signal PR and the counterclockwise direction command signal LC or the clockwise direction command signal RC for driving the analogue switch Q1 incorporated in the sample-and-hold circuit 61.

Assuming, by way of example, that the integrating circuit incorporated in the delay circuit 63 is implemented in a simple structure such that the integrating circuit operates with a single time constant, the hold timing is delayed similarly to the delay of the sample timing for the switch driving signal SD, possibly giving rise to inconvenience that sample timing and hold timing can not be established appropriately or correctly.

By contrast, the delay circuit 63 according to the instant embodiment of the invention is implemented in such arrangement that different time constants can be set for the delays of the sample timing and the hold timing independent of each other for the purpose of optimizing both the sample timing and the hold timing, respectively.

More specifically, the gate circuit 62 sets the output of the NAND gate 64 to high level (H) to thereby validate the NAND gate 65 only when the control unit 31 operates normally and one of the counterclockwise direction command signal LC and the clockwise direction command signal RC is inputted, whereby the switch driving signal SD is outputted in synchronism with the PWM delay signal PR.

By contrast, when the control unit 31 operates abnormally and both the counterclockwise direction command signal LC and the clockwise direction command signal RC are at high level (H), the gate circuit 62 sets the output of the NAND gate 64 to low level (L) to thereby disable the NAND gate 65 and fix the switch driving signal SD at a high level (H). Consequently, the analogue switch Q1 remains continuously in the on-state with the sample-and-hold circuit 61 being left constantly in the sampling state, making it possible to detect an abnormal current event due to a fault in the FET driving circuit 7 or the like.

Parenthetically, it should be mentioned that in the case of the circuit configuration shown in Fig. 3, the switch driving signal SD is outputted in synchronism with the PWM delay signal PR even when both the counterclockwise direction command signal LC and the clockwise direction command signal RC are at low or "L" level, with a view to implementing the circuit in a simplified configuration.

However, it is preferred to implement the gate circuit 62 such that the switch driving signal SD is fixed to the high "H" level when both the counterclockwise direction command signal LC and the clockwise direction command signal RC are at the low "L" level, because the FETs of the H-bridge circuit 4 are not driven at that time, although the circuit configuration of concern is not shown.

As can be seen in Fig. 1, the amplifier circuit 10 is constituted by a non-inverting amplifier circuit including the differential amplifier 11, the resistors R11 to R17 and the level shifting PNP-transistor Q10, whereby the hold voltage V2 inputted by way of the sample-and-hold circuit 61 is amplified with reference to the power-supply voltage VB used as the standard.

Furthermore, the amplifier circuit 10 includes a constant-current circuit constituted by the level shifting PNP-transistor Q10 and the resistors R13 and R14, wherein the voltage amplified by the differential amplifier 11 is shifted to a voltage level fixed relative to a given ground level, e.g. the second ground level Gnd2, whereby the output of the amplifier circuit 10 is supplied to the control unit 31 as the detection voltage Vo.

In the amplifier circuit 10, the pull-up resistor R15 contributes to improvement of the response performance of the differential amplifier 11 in outputting a voltage signal having a level approximating to that the power-supply voltage VB.

Further, the serial resistors R16 and R17 constitute an integrating circuit incorporation with a transistor input capacity (i.e., parasitic capacity between the collector and the base of the transistor) internally of the differential amplifier 11, wherein the integrating circuit serves to suppress variation of the base current in the input stage of the differential amplifier 11. To say in another way, owing to the integrating circuit mentioned above, noise components contained in the voltage signal inputted to the differential amplifier 11 can be reduced.

Turning back to Fig. 1, the detection voltage Vo fed back to the control unit 31 from the motor current detecting circuit composed of the amplifier circuit 10, the negative voltage power-supply circuit 20, the sample-and-hold circuit 61, the gate circuit 62 and the delay circuit 63 is transformed by the resistor R14 into a given potential level relative to the standard level represented by the second ground level Gnd2.

However, because the detection voltage Vo is outputted from the constant current circuit as mentioned hereinbefore, the resistor R14 may be connected to the intrinsic ground potential relative to the analogue ground level for the A/D converter in the case where the analogue ground level for the A/D converter is isolated from the other ground level for the control unit 31.

The control unit 31 responds to the input of the detection voltage Vo from the amplifier circuit 10 for arithmetically determining or calculating the DC value of the motor current IM on the basis of the detection voltage Vo to thereby effectuate the feedback control of the motor current IM by outputting the command signals including the PWM signal PW and the counterclockwise direction command signal LC or the clockwise direction command signal RC by resorting to the conventional control process such as the PID control so that deviation of the DC value from the desired or target current can be reduced to a minimum.

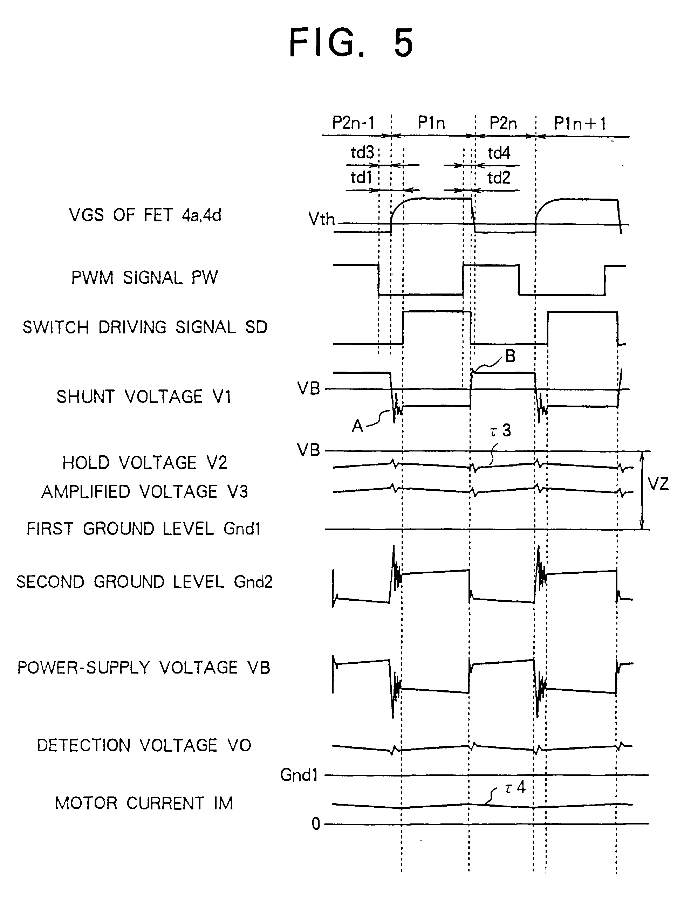

Now, description will turn to the operation for detecting the motor current IM in the high-side type motor current detecting circuit according to the first embodiment of the invention (shown in Figs. 1 to 3) by reference to waveform diagrams shown in Fig. 4 and 5 together with equivalent circuit diagrams shown in Figs. 12 to 14.

Figure 5 is a waveform diagram for illustrating various voltage signals making appearance in the high-side type motor current detecting circuit upon driving the FETs constituting the H-bridge circuit 4. Incidentally, in a waveform diagram shown in Fig. 5, it is assumed that the FETs 4a and 4d for rotating the motor M in the counterclockwise direction (see Fig. 10) are driven with the FET driving signals VGS for the FETs 4a and 4d (i.e., gate-source voltages of these FETs) being changed over for acquiring the detection voltage Vo.

Referring to Fig. 5, the FETs 4a and 4d are in the on-state during intervals P1n and P1n+1 while they are in the off-state during the intervals P2n-1 and P2n.

The switch driving signal SD rises up with a time delay tdl relative to the pulse edge of the PWM signal PW and falls after lapse of a time delay td2, while the FET driving signal VGS rises with a time delay td3 and falls after lapse of a time delay td4.

In conjunction with the waveforms shown in Fig. 5, it should further be added that the voltages V1 to V3 and the first and second ground levels Gnd1 and Gnd2 are measured with reference to the power-supply voltage VB while the power-supply voltage VB and the detection voltage Vo are measured with reference to the second ground level Gnd2 serving as the reference or standard.

At first, description will be directed to the sample-and-hold operation of the sample-and-hold circuit 61 for the shunt voltage V1.

The FET driving circuit 7 turns on/off a pair of the FETs 4a and 4d or other pair of the FETs 4b and 4c of the H-bridge circuit 4 in accordance with the individual command signal of the counterclockwise direction command signal LC or the clockwise direction command signal RC in synchronism with the PWM signal PW.

The shunt voltage V1 appearing across the shunt resistor Rs can be given by the following expression:

$$V1 = rs \cdot i$$

where rs represents the resistance value of the shunt resistor Rs and i represents the current flowing through the shunt resistor Rs.

For measuring the conduction current of the motor M, i.e., the motor current IM, the shunt voltage V1 may be sampled during the interval or period P1n. However, in consideration of the fact that switching noise (shown at A in Fig. 5) is produced at the moment the FET driving signal VGS exceeds the threshold value Vth, the shunt voltage V1 should preferably be sampled at a time point which does not fall within the period P1n in order to enhance the detection accuracy of the motor current IM.

Accordingly, the discharging resistor R3 incorporated in the delay circuit 63 (see Fig. 3) is designed to have a large resistance value to thereby set a large value for the time constant $\tau1$ (see Fig. 4) of the integrating circuit composed of the resistor R3 and the capacitor C3.

With the arrangement mentioned above, the delay time tdl involved in the rise-up of the switch driving signal SD becomes longer than the time delay td3 in the rise-up of the FET driving signal VGS, as shown in Fig. 5.

As a result of this, the shunt voltage V1 appearing across the shunt resistor Rs is sampled and held at a time point after the switching noise (A) mentioned previously has occurred, whereby the influence of the switching noise can be eliminated.

Subsequently, during the period or interval P2n, the FETs 4a and 4d are turned off to allow a regenerative current i2 to flow (see Fig. 13). At this time point, the sample-and-hold circuit 61 discharges electric charges stored in the capacitor C1 through the sampling operation.

In this case, noise components are superposed on the shunt voltage V1 (as indicated at B in Fig. 5) due to the regenerative current i2. Accordingly, the sampling of the noise component should be evaded for thereby preventing the unwanted discharge of the electric charges.

Accordingly, the charging resistor R2 incorporated in the delay circuit 63 (see Fig. 3) is designed to have a small resistance value to thereby set a large value for the time constant $\tau2$ (see Fig. 4) of the integrating circuit composed of the resistor R2 and the capacitor C3.

With the arrangement mentioned above, the delay time td2 involved in rising of the switch driving signal SD becomes shorter than the time delay td4 in the rise-up of the FET driving signal VGS, as shown in Fig. 5.

In this manner, the sampling-and-hold operation for the shunt voltage V1 is completed before generation of noise (B), whereby unwanted discharge due to the regenerative current noise can be evaded.

The hold voltage V2 sampled in this manner represents a voltage having negative polarity obtained by sampling the shunt voltage V1 appearing across the shunt resistor Rs upon energization of the motor M with reference to the power-supply voltage VB serving as the standard, as shown in Fig. 5, wherein the sampled voltage is discharged with the time constant $\tau3$ determined by the resistor R1 and the capacitor C1 of the sample-and-hold circuit 61.

As will be understood from the forgoing description, the time constant $\tau3$ for the hold voltage V2 during the non-sampling period can be set similarly to the time constant $\tau4$ when the motor current IM decreases due to the regenerative current i2, for obtaining the hold voltage V2 with high accuracy in following the motor current IM. In practical applications, the time constant $\tau4$ at which the motor current IM decreases should previously be measured to thereby determine the time constant $\tau3$ so that it coincides substantially with the time constant $\tau4$. Parenthetically, the motor current IM is determined by the battery 9 and the motor M employed actually.

The amplifier circuit 10 amplifies the hold voltage V2 with reference to the power-supply voltage VB, as a result of which an amplified voltage V3 is generated across the resistor R13. At that time, the resistors R11 and R12 (having respective resistance values r11 and r12) determine a first gain for generating the amplified voltage V3 which can thus be given by the following expression:

$$V3 = 1 + r12 / r11$$

Further, in the amplifier circuit 10, the constant-current circuit including the level shifting PNP-transistor Q10 amplifies the amplified voltage V3 to thereby output the detection voltage Vo with reference to the second ground level Gnd2. In that case, the resistors R13 and R14 (having resistance values r13 and r14), respectively, determine a second gain for generating the detection voltage Vo which can thus be expressed as follows:

$$Vo = V3 \cdot r14 / r13$$

Referring to Fig. 5 and observing the hold voltage V2 with reference to the power-supply voltage VB, the hold voltage V2 can be regarded substantially as a DC voltage, whereas when the hold voltage V2 is observed with reference to the second ground level Gnd2, the hold voltage V2 presents an AC voltage waveform which is substantially in synchronism with variation of the power-supply voltage VB (corresponding to variation of the shunt voltage V1).

For the reason mentioned above, the first ground level Gndl for the differential amplifier 11 of the amplifier circuit 10 is separated or isolated from the second ground level Gnd2 for the other circuitries and grounded, so to say, to a stable negative constant-voltage power supply (i.e., first ground level Gnd1) in the negative voltage power-supply circuit 20.

The Zener diode ZD incorporated in the negative voltage power-supply circuit 20 operates to stabilize the driving voltage Vop for the amplifier circuit 10 and the first ground level Gnd1 to the voltage VZ with reference to the power-supply voltage VB, to thereby suppress the variation of the power-supply voltage VB brought about by the energization of the motor M and the regenerative current i2.

On the other hand, the decoupling capacitor C21 of the negative voltage power-supply circuit 20 is effective for reducing high-frequency switching noise components superposed on the current flowing through the power-supply line. Thus, the input signal for the differential amplifier 11 as well as the driving voltage Vop and the first ground level Gndl are sustained essentially as DC voltages, respectively.

Owing to this feature, stable power supply to the differential amplifier 11 can be realized, which in turn means that the amplified voltage V3 can be stabilized satisfactorily.

Additionally, by virtue of the circuit arrangement described above, the amplifier circuit 10 ensuring high accuracy in operation can be realized by using a general-purpose differential amplifier having a cut-off frequency $f_T$ on the order of 1 M Hz as the differential amplifier 11 even in the high-side type motor current detecting circuit which is highly susceptible to the influence of variation of the power-supply voltage VB brought about by energization of the motor M.

Similarly, the current detection error ascribable to variation in the power-supply voltage can be suppressed by using an inexpensive differential amplifier as the differential amplifier 11 without being affected by the high-frequency characteristics (power-supply voltage variation eliminating ratio SVR) of the differential amplifier 11 regardless of magnitude of variation of the power-supply voltage VB brought about upon energization or power-on of the motor M.

Besides, because the differential amplifier 11 of the amplifier circuit 10 is implemented in a single stage, there can not arise such a problem that offsets of the interconnected differential amplifiers 51 to 53 are cumulated, as mentioned hereinbefore in conjunction with the conventional high-side type motor current detecting circuit shown in Fig. 11.

Furthermore, owing to the capability of transforming the detection voltage Vo to a given reference ground potential level by means of the constant-current circuit including the level shifting PNP-transistor Q10, there is no more required the reference voltage Vr mentioned previously by reference to Fig. 11.

Moreover, owing to the two time constants τ1 and τ2 validated for discharging and charging in the delay circuit 63 to thereby delay the time point for the sampling operation of the sample-and-hold circuit 61 relative to the timing at which the relevant FETs of the H-bridge circuit 4 are turned on while setting the hold timing immediately before the time point for turning off the FETs, switching noise components generated upon turning on/off of the FETs can be avoided with the unwanted discharging being prevented during the hold period. In this way, the current detection error can be suppressed sufficiently regardless of the operation frequency characteristics of the differential amplifier 11 or the amplifier circuit 10 as a whole.

Embodiment 2

In the case of the high-side type motor current detecting circuit according to the first embodiment of the invention, only the negative constant voltage circuit including the Zener diode ZD is employed as the negative voltage power-supply circuit 20. However, it is equally possible to employ the negative voltage power supply circuit including a positive constant voltage circuit of charge-pump type in combination with the power-supply voltage VB serving as the reference potential source.

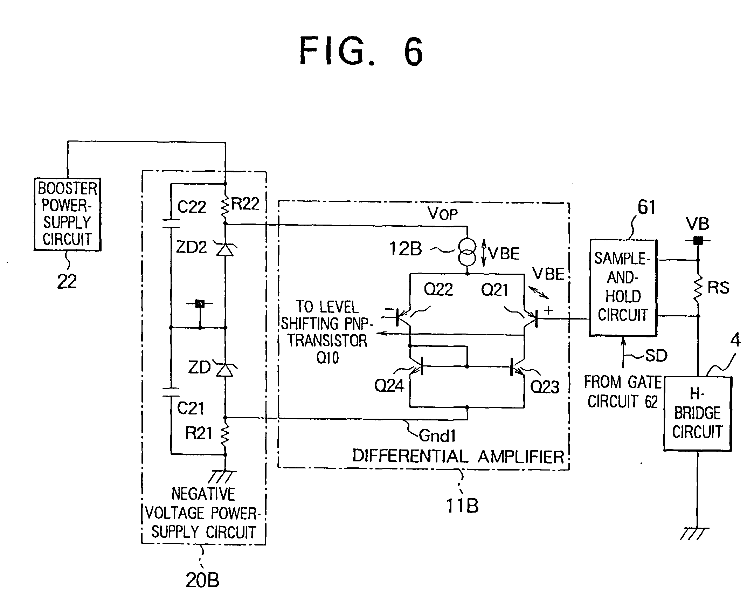

Figure 6 is a circuit diagram showing a negative voltage power-supply circuit 20B and a differential amplifier 11B according to a second embodiment of the invention.

As can be seen in the figure, a booster power-supply circuit 22 is additionally provided for the negative voltage power-supply circuit 20B. Thus, in the high-side type motor current detecting circuit according to the instant embodiment of the invention, there are employed not only the negative constant voltage circuit described hereinbefore but also a positive constant voltage circuit. Further, the input circuitry of the differential amplifier 11B is implemented by using the PNP-transistors. Parenthetically, in Fig. 6, illustration of the serial resistors R17 and R18 is omitted for the simplification of the drawing.

The negative voltage power-supply circuit 20B includes in addition to the negative constant voltage circuit (composed of the Zener diode ZD, the capacitor C21 and resistor R21), a Zener diode ZD2 connected in series to the Zener diode ZD, a booster power-supply circuit 22 connected in series to the capacitor C21 and a resistor R22, wherein the Zener diode ZD2, the capacitor C22 and the resistor R22 constitutes a constant-voltage power supply of positive or plus polarity.

Applied to the junction between the capacitor C22 and the resistor R22 is a voltage supplied from the booster power-supply circuit 22, while the power-supply voltage VB is applied to a junction between the anode of the Zener diode ZD2 and the capacitor C22. With this circuit arrangement, the driving voltage Vop for the differential amplifier 11B is outputted from the junction between the resistor R22 and Zener diode ZD2.

On the other hand, the first ground level Gnd1 mentioned previously is outputted from the junction between the Zener diode ZD and the resistor R21.

The differential amplifier 11B is comprised of the PNP-transistor Q21 having a base serving as the non-inverting input terminal (+), a PNP-transistor Q22 having a base serving as the inverting input terminal (-), an NPN-transistor Q23 having a collector connected to that of the PNP-transistor Q21, an NPN-transistor Q24 having a collector connected to that of the PNP-transistor Q22 and a constant-current source 12B connected to the emitters of the PNP-transistors Q21 and Q22, which emitters are connected together.

In the differential amplifier 11B, cathode potential of the Zener diode ZD2 is applied to the other end of the constant-current source 12B as the driving voltage Vop for the differential amplifier 11B, whereas anode potential of the Zener diode ZD, i.e., the first ground level Gnd1, is applied to the emitters of the NPN-transistors Q23 and Q24, respectively.

In the differential amplifier 11B shown in Fig. 6, operation range of the input voltage is limited to a value "Vop - 2VBE", where VBE represents a voltage drop in the constant-current source 12B incorporated in the differential amplifier 11B. Accordingly, for ensuring the voltage amplification with reference to the power-supply voltage VB, it is required to employ the booster power-supply circuit 22 for the driving voltage Vop.

In this case, the negative voltage power-supply circuit 20B generates as the driving voltage Vop a constant voltage of positive polarity with reference to or relative to the power-supply voltage VB and generates as the first ground level Gnd1 a constant voltage of negative polarity relative to the power-supply voltage VB.

Except for the difference described above, the high-side type motor current detecting circuit according to the instant embodiment of the invention operates in the same manner as that of the first embodiment. Accordingly, repetitive operation thereof will be unnecessary.

By using the negative voltage power-supply circuit 20B of the charge-pump type as described above, the present invention can equally be applied to the differential amplifier 11B including the PNP-transistor input circuitry, whereby the detection voltage Vo can be obtained with high accuracy.

Embodiment 3

In conjunction with the first embodiment of the invention, no description has been made as to hardware implementation or packaging of the high-side type motor current detecting circuit. A third embodiment of the invention is directed to realization of the high-side type motor current detecting circuit in a monolithic integrated circuit or IC structure.

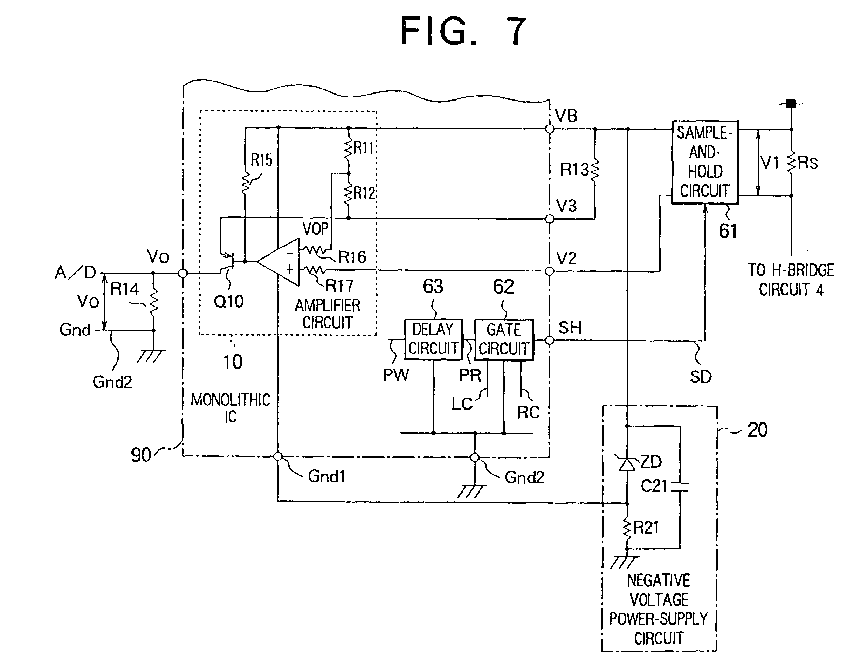

Figure 7 is a circuit block diagram showing a configuration of the high-side type motor current detecting circuit according to the third embodiment of the invention which is suited for implementation as a monolithic IC. More specifically, the amplifier circuit 10, the gate circuit 62 and the delay circuit 63 are incorporated in a monolithic IC 90.

Referring to Fig. 7, it should first be mentioned that the first ground level Gnd1 and the second ground level Gnd2 are separated or isolated from each other internally of the monolithic IC 90.

The negative voltage power-supply circuit 20 operates to stabilize the voltage or potential difference between the power-supply voltage VB of the main power-supply circuit and the first ground level Gnd1 at a constant value.

However, because there exists inevitably coupling capacitance between the components of the individual circuits and a substrate (silicon substrate) of the monolithic IC 90 even though the first ground level Gnd1 and the second ground level Gnd2 are separated or isolated from each other internally of the monolithic IC 90, it is desirable for practical applications to realize the isolation more completely with AC components being also taken into account by resorting to the conventional isolation techniques based on use of an oxide film ($SiO_2$-film).

In the case of the high-side type motor current detecting circuit according to the instant embodiment of the invention, the first ground level Gnd1 and the second ground level Gnd2 are separated or isolated from each other internally of the monolithic IC 90, and a constant voltage power supply (negative voltage power-supply circuit 20) is additionally provided in combination with the power-supply voltage VB serving as the reference. Thus, there can be realized internally of the monolithic IC 90 the amplifier circuit 10 and the circuitries such as the switch driving signal generating circuit (the gate circuit 62 and the delay circuit 63) which operate with reference to the second ground level Gnd2.

In the high-side type motor current detecting circuit described above, the negative voltage power-supply circuit 20 is mounted externally of the monolithic IC 90 with a view to reducing the power consumption internally of the monolithic IC 90. However, it goes without saying that the negative voltage power-supply circuit 20 may be built in the monolithic IC 90.

Further, in order to make it possible to set the amplification gain of the amplifier circuit 10 externally of the monolithic IC 90, the resistors R13 and R14 of the amplifier circuit 10 are provided exteriorly of the monolithic IC 90. However, in the practical applications where the gain of the amplifier circuit 10 can be fixed, the resistors R13 and R14 may be incorporated in the monolithic IC 90.

Reversely, the resistors R11 and R12 may be provided externally of the monolithic IC 90 with the resistors R13 and R14 being incorporated in the monolithic IC 90.

In general, the resistor to be provided internally of an integrated circuit or IC is implemented as a semiconductor resistor formed by diffusing impurity into a base region of a transistor. Such semiconductor resistor can be realized with high accuracy in respect to a relative value such as resistance ratio although absolute accuracy such as that of resistivity is low more or less. On the other hand, the resistor to be provided externally of the IC is usually implemented in the form of a carbon film, a metal film or the like with high accuracy in respect to the resistivity in the absolute sense, whereas the accuracy in the relative sense such as that for the resistance ratio is low. For these reasons, it is preferred that the resistors (e.g. resistors R13 and R14) which play an important role in determining the gain of amplification, as mentioned previously, should be provided in a pair internally or externally of the IC.

Embodiment 4

In the high-side type motor current detecting circuit according to the third embodiment, no description has been especially made of the positional relation among the individual terminals of the integrated circuit or IC. In this conjunction, it is noted that the output terminal of the resistor R13 and the input terminal of the power-supply voltage VB can be disposed close to each other.

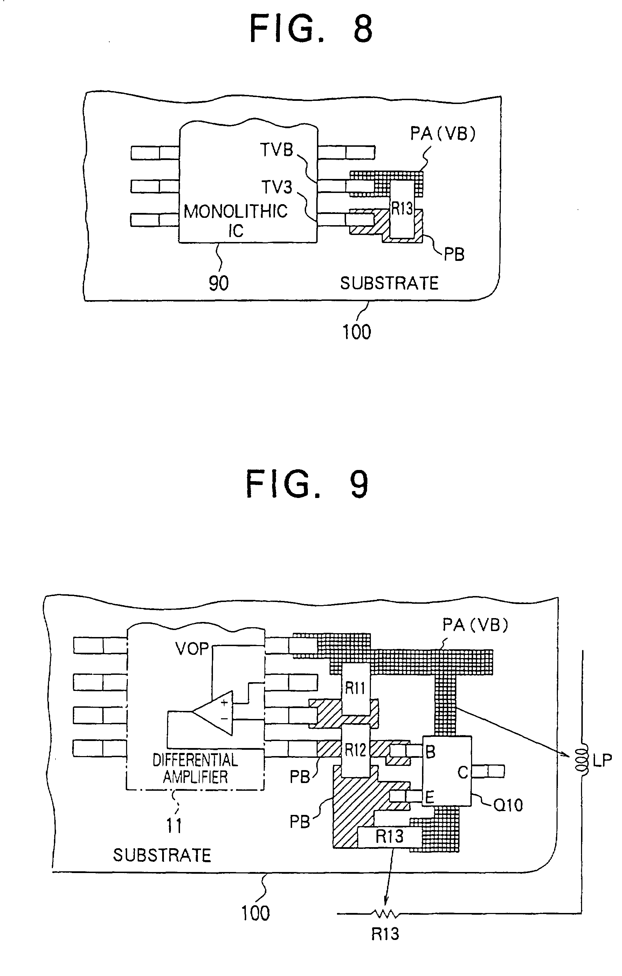

Figure 8 is a top plan view which shows fragmentarily an outer appearance of a high-side type motor current detecting circuit according to a fourth embodiment of the invention with some parts in section. It is taught according to the invention incarnated in the instant embodiment that a power supply terminal TVB of the monolithic IC 90 and a connecting terminal TV3 of the resistor R13 are disposed in proximity to each other.

More specifically, referring to Fig. 8, one end portion of the resistor R13 is connected to the power supply terminal TVB of the monolithic IC 90 by way of a patterned conductor PA to which the power-supply voltage VB is applied, while the other end portion of the resistor R13 to which the amplified voltage V3 is applied is connected to a connecting terminal TV3 of the monolithic IC 90 via a patterned conductor PB.

The monolithic IC 90 and the resistor R13 are mounted or packaged on the substrate 100, wherein the power supply terminal TVB and the connecting terminal TV3 of the monolithic IC 90 are disposed adjacent to each other with the resistor R13 being mounted in the vicinity of the terminals TVB and TV3.

Figure 9 is a plan view showing partially in section an exemplary package for comparison with the monolithic IC structure shown in Fig. 8. As can be seen in Fig. 9, the differential amplifier 11, the resistor R13 and the level shifting PNP-transistor Q10 are mounted as discrete components. In the case of the device shown in Fig. 9, the patterned conductor PA will present large inductance LP because of a great wiring length thereof.

Since the counterclockwise drive PWM signal LP applied by way of the patterned conductor PA brings about a phase difference in AC component between the power-supply voltage VB and the terminal voltage applied to the patterned conductor PA for the resistor R13, the counterclockwise drive PWM signal LP should be suppressed to a possible minimum.

In this conjunction, comparison of the wiring in the IC device shown in Fig. 8 with the discrete package of the individual components in the device shown in Fig. 9 shows that the wiring length of the patterned conductor PA is shortened to a possible minimum, whereby the counterclockwise drive PWM signal LP of the patterned conductor PA can be suppressed significantly.

As is apparent from the above, by mounting the resistor R13 on the power supply terminal TVB and the power supply terminal TVB which in turn are mounted on the monolithic IC 90 adjacent to each other, it is possible to suppress to a possible minimum the inductance LP of the patterned conductor PA extending between the power supply terminal TVB of the monolithic IC 90 and the reference voltage terminal of the resistor R13 (terminal for the power-supply voltage VB).

Thus, by virtue of the arrangement described above, the phase difference in the AC component between the reference voltage applied to the power supply terminal TVB of the amplifier circuit 10 formed on the monolithic IC 90 and the reference voltage (power-supply voltage VB) applied to the patterned conductor PA for the resistor R13 can be reduced, whereby the detection error can further be suppressed.

Modifications

By way of example, although the power supply terminal TVB and the connecting terminal TV3 of the resistor R13 are disposed adjacent to each other in the case of the IC device according to the fourth embodiment (Fig. 8), these terminals TVB and TV3 may be mounted with a distance corresponding to one or more terminals substantially to the same effect in consideration of the fact that the conductors or leads tend to be mounted with more and more fine pitch owing to progress in the packaging technique in these years.

In each of the high-side type motor current detecting circuits described above in conjunction with the exemplary embodiments of the invention, the resistors R17 and R18 are provided in association with the input terminals of the differential amplifier 11 in an effort to eliminate the switching noise which may otherwise be superposed on the hold voltage V2 so that the resistors R17 and R18 constitute an integrating circuit in cooperation with the input capacitance of the differential amplifier 11. However, so far as influence of the noise component affecting desired accuracy of amplification is within a permissible range, the resistors R17 and R18 may be spared.

Further, in the foregoing description, it has been assumed that a digital servo-control based on a microcomputer is adopted for controlling the motor current IM. However, the invention is never restricted thereto. It goes without saying that the present invention can equally be applied to the motor control in which an analogue servo control resorting to the differential amplifier is adopted.

**Claims**

1. A high-side type motor current detecting circuit, comprising:

   a plurality of FETs (4a, 4d; 4b, 4c) constituting an H-bridge circuit (4);

   an electric motor (M) connected to said H-bridge circuit (4) ;

   control means (31) for commanding a direction of a current flow through said electric motor (M) and magnitude of said current flow;

   a main power-supply circuit (9, Cr) for supplying a motor current (IM) to said H-bridge circuit (4) for driving said electric motor (M);

   a shunt resistor (Rs) inserted between said H-bridge circuit (4) and said main power-supply circuit (9, Cr) ;

   characterized by

   a FET (field-effect transistor) driving circuit (7) for driving said FETs (4a, 4d; 4b, 4c) with PWM (pulse-width modulated) signals in accordance with a command signal (PW, LC, RC) issued by said control means (31);

   a sample-and-hold circuit (61) including an analogue switch (Q1) for sampling a voltage (V1) detected across said shunt resistor (Rs) when said FETs (4a, 4d; 4b, 4c) are tuned on in synchronism with said command signal (PW, LC, RC) said sample-an-hold circuit (61) holding said voltage (V1) when said FETs (4a, 4d; 4b, 4c) are turned off;

   an amplifier circuit (10) including a differential amplifier (11) for amplifying the voltage (V2) held by said sample-and-hold circuit (61), for thereby supplying a detection voltage (Vo) corresponding to said motor current (IM) to said control means (31);

   a negative voltage power-supply circuit (20) provided between said sample-and-hold circuit (61) and said amplifier circuit (10) for generating a first ground level (Gnd1) for said amplifier circuit (10); and

   a switch driving signal generating circuit (62,63) for generating a switch driving signal (SD) for turning on/off said analogue switch (Q1) in synchronism with said command signal (PW, LC, RC),

   wherein said amplifier circuit (10) includes a constant-current circuit (Q10, R13, R14) for shifting a voltage level of said detection voltage (Vo) to a given ground level; and

   wherein said first ground level (Gnd1) is isolated from a second ground level (Gnd2) for other circuits than said differential amplifier (11) and given by a negative constant voltage with reference to a power-supply voltage (VB) of said main power-supply circuit (9, Cr); and

   whereby amplification error involved in amplification of said detection voltage signal (Vo) as brought about by variation of the voltage (VB) of said main power-supply circuit (9, Cr) upon flowing of said motor current (IM) through said electric motor (M) is suppressed.

2. A high-side type motor current detecting circuit according to claim 1,

   wherein said differential amplifier (11) includes an NPN-transistor input circuit (Q11, ..., Q16); and
   wherein said negative voltage power-supply circuit (20) includes a capacitor (C21) inserted between said main power-supply circuit (9, Cr) and said second ground level (Gnd2), a Zener diode (ZD) connected in parallel with said capacitor (C21) and having a cathode terminal connected to said main power-supply circuit (9, Cr), and a resistor (R21) connected in series to an anode terminal of said Zener diode (ZD), said first ground level (Gnd1) being generated from the anode terminal of said Zener diode (ZD).

3. A high-side type motor current detecting circuit according to claim 1,

   wherein said differential amplifier (11B) includes a PNP-transistor input circuit (Q22, Q21); and

wherein said negative voltage power-supply circuit (20B) includes a positive constant-voltage power supply (ZD2, C22, R22) and a negative constant-voltage power supply (ZD, C21, R21) for generating positive and negative constant voltages having positive and negative polarities, respectively, with reference to the power-supply voltage (VB) of said main power-supply circuit (9, Cr).

4. A high-side type motor current detecting circuit according to claim 1,

wherein said switch driving signal generating circuit (62, 63) includes a delay circuit (63) for setting different delay times, respectively, for rising and falling of said switch driving signal (SD).

5. A high-side type motor current detecting circuit according to claim 1,

said constant-current circuit including:

a level-shift dedicated PNP-transistor (Q10) provided at the output side of said amplifier circuit (10) and having a base connected to the output terminal of said differential amplifier;
a first resistor (R11) inserted between an inverting input terminal of said differential amplifier (11) and said main power-supply circuit (9, Cr);
a second resistor (R12) inserted between said inverting input terminal of said differential amplifier (11, 11B) and an emitter terminal of said level-shift dedicated PNP-transistor (Q10);
a third resistor (R13) inserted between said main power-supply circuit (9, Cr) and the emitter terminal of said level-shift dedicated PNP-transistor (Q10); and
a fourth resistor (R14) inserted between a collector terminal of said level-shift dedicated PNP-transistor (Q10) and said second ground level (Gnd2),
wherein a first gain of said amplifier circuit (10) is determined by said first and second resistors (R11, R12), while a second gain of said amplifier circuit (10) is determined by said third and fourth resistors (R13, R14).

6. A high-side type motor current detecting circuit according to claim 1,

said motor current detecting circuit (50) being implemented in the form of a monolithic integrated circuit (90),
wherein said first and second ground levels (Gnd1, Gnd2) are isolated from each other internally of said monolithic integrated circuit (90).

7. A high-side type motor current detecting circuit according to claim 5,

said amplifier circuit (10) being implemented in the form of a monolithic integrated circuit (90), wherein said monolithic integrated circuit (90) includes
said differential amplifier (11);
said first and second resistors (R11, R12);
said level-shift dedicated PNP-transistor (Q10);
a first terminal (TVB) to which a power-supply voltage (VB) is applied from said main power-supply circuit (9, Cr) as a reference voltage for said amplifier circuit (10); and
a second terminal (TV3) to which one end of said third resistor (R13) is connected, said third resister (R13) having the other end connected to said first terminal (TVB); and
wherein said first and second terminals (TVB, TV3) are disposed closely to each other, and wherein said third resistor (R13) being disposed externally of said monolithic integrated circuit (90).

8. A high-side type motor current detecting circuit according to claim 1,

wherein resistors (R17, R18) are connected in series to input terminals of said differential amplifier (11), respectively.

**Patentansprüche**

1. Eine Motorstromerfassungsschaltung vom oberseitigen Typ, umfassend:

eine Vielzahl von FETs (4a, 4d; 4b, 4c), die eine H-Brückenschaltung (4) bilden;

einen elektrischen Motor (M), der mit der H-Brückenschaltung (4) verbunden ist;

eine Steuervorrichtung (31) zum Anweisen einer Richtung eines Stromflusses durch den elektrischen Motor (M) und einer Größe des Stromflusses;

eine Hauptenergieversorgungsschaltung (9, Cr) zum Liefern eines Motorstroms (IM) an die H-Brückenschaltung (4) zum Ansteuern des elektrischen Motors (M) ;

einen Nebenschlusswiderstand (Rs), eingefügt zwischen die H-Brückenschaltung (4) und die Hauptenergieversorgungsschaltung (9, Cr);

gekennzeichnet durch

eine FET (Feldeffekttransistor) Ansteuerschaltung (7) zum Ansteuern der FETs (4a, 4d; 4b, 4c) mit PWM (pulsweitenmodulierten) Signalen, in Übereinstimmung mit einem durch die Steuervorrichtung (31) ausgegebenen Befehlssignal (PW, LC, RC);

eine Abtast-und-Halteschaltung (61) einschließlich eines analogen Schalters (Q1) zum Abtasten einer Spannung (V1), die über dem Nebenschlusswiderstand (Rs) erfasst wird, wenn die FETs (4a, 4d; 4b, 4c) mit dem Befehlssignal (PW, LC, RC) synchron angeschaltet werden, wobei die Abtast-und-Halteschaltung (61) die Spannung (V1) hält, wenn die FETs (4a, 4d; 4b, 4c) ausgeschaltet werden;

eine Verstärkerschaltung (10) mit einem Operationsverstärker (11) zum Verstärken der Spannung (V2), die durch die Abtast-und-Halteschaltung (61) gehalten wird, um dadurch eine Erfassungsspannung (Vo) entsprechend dem Motorstrom (IM) an die Steuervorrichtung (31) zu liefern;

eine Energieversorgungsschaltung für eine negative Spannung (20), die zwischen der Abtast-und-Halteschaltung (61) und der Verstärkerschaltung (10) angeordnet ist, um einen ersten Massepegel (Gnd1) für die Verstärkerschaltung (10) zu erzeugen; und

eine Schaltansteuersignalerzeugungsschaltung (62, 63) zum Erzeugen eines Schaltansteuersignals (SD) zum An/Ausschalten des analogen Schalters (Q1) synchron mit dem Befehlssignal (PW, LC, RC),

wobei die Verstärkerschaltung (10) eine Konstantstromquelle (Q10, R13, R14) umfasst, um einen Spannungspegel der Erfassungsspannung (Vo) auf einen gegebenen Massepegel zu verschieben; und

wobei der erste Massepegel (Gnd1) vom zweiten Massepegel (Gnd2) für Schaltungen außer dem Operationsverstärker (11) isoliert ist, durch eine negative Konstantspannung mit Bezug auf eine Energieversorgungsspannung (VB) der Hauptenergieversorgungsschaltung (9, Cr) gegeben; und wobei ein Verstärkungsfehler bei einer Verstärkung des Erfassungsspannungssignals (Vo) unterdrückt wird, bewirkt durch eine Veränderung der Spannung (VB) der Hauptenergieversorgungsschaltung (9, Cr) bei einem Fließen des Motorstroms (IM) durch den elektrischen Motor (M).

2. Eine Motorstromerfassungsschaltung vom oberseitigen Typ nach Anspruch 1,

wobei der Operationsverstärker (11) eine NPN-Transistoreingangsschaltung (Q11, ..., Q16) umfasst; und

wobei die Energieversorgungsschaltung für eine negative Spannung (20) einen Kondensator (C21) umfasst, der zwischen der Hauptenergieversorgungsschaltung (9, Cr) und dem zweiten Massepegel (Gnd2) angeordnet ist, eine Zenerdiode (ZD), die parallel zum Kondensator (C21) verbunden ist, und deren Kathodenanschluss mit der Hauptenergieversorgungsschaltung (9, Cr) verbunden ist, einen Widerstand (R21), der in Serie mit einem Anodenanschluss der Zenerdiode (ZD) verbunden ist, wobei der erste Massepegel (Gndl) an dem Anodenanschluss der Zenerdiode (ZD) erzeugt wird.

3. Eine Motorstromerfassungsschaltung vom oberseitigen Typ nach Anspruch 1,

wobei der Operationsverstärker (11B) eine PNP-Transistoreingangsschaltung (Q22, Q21) umfasst; und

wobei die Energieversorgungsschaltung für eine negative Spannung (20B) eine positive Konstantspannungsenergieversorgung (ZD2, C22, R22) und eine negative Konstantspannungsenergieversorgung (ZD, C21, R21) umfasst, um eine positive und negative Konstantspannung mit positiver bzw. negativer Polarität zu erzeugen, mit Bezug auf die Energieversorgungsspannung (VB) der Hauptenergieversorgungsschaltung (9, Cr).

4. Eine Motorstromerfassungsschaltung vom oberseitigen Typ nach Anspruch 1, wobei die Schaltansteuersignalerzeugungsschaltung (62, 63) eine Verzögerungsschaltung (63) umfasst, um unterschiedliche Verzögerungszeiten jeweilig einzustellen, um das Schaltansteuersignal (SD) zu setzen und zu löschen.

5. Eine Motorstromerfassungsschaltung vom oberseitigen Typ nach Anspruch 1, wobei die Konstantstromschaltung umfasst:

einen pegelschiebezweckbestimmten PNP-Transistor (Q10), der an der Ausgangsseite der Verstärkerschaltung (10) bereitgestellt ist und dessen Basis mit dem Ausgangsanschluss des Operationsverstärkers verbunden ist;

einen ersten Widerstand (R11), der zwischen einem invertierenden Eingangsanschluss des Operationsverstärkers (11) und der Hauptenergieversorgungsschaltung (9, Cr) angeordnet ist;

einen zweiten Widerstand (R12), der zwischen dem invertierenden Eingangsanschluss des Operationsverstärkers (11, 11B) und einem Emitteranschluss des pegelschiebezweckbestimmten PNP-Transistor (Q10) angeordnet ist;

einen dritten Widerstand (R13), der zwischen der Hauptenergieversorgungsschaltung (9, Cr) und dem Emitteranschluss des pegelschiebezweckbestimmten PNP-Transistors (Q10) angeordnet ist; und

einen vierten Widerstand (R14), der zwischen einem Kollektoranschluss des pegelschiebezweckbestimmten PNP-Transistors (Q10) und dem zweiten Massepegel (Gnd2) angeordnet ist,

wobei eine erste Verstärkung der Verstärkerschaltung (10) durch den ersten und zweiten Widerstand (R11, R12) bestimmt ist, während eine zweite Verstärkung der Verstärkerschaltung (10) durch den dritten und vierten Widerstand (R13, R14) bestimmt ist.

6. Eine Motorstromerfassungsschaltung vom oberseitigen Typ nach Anspruch 1,

wobei die Motorstromerfassungsschaltung (50) in der Form einer monolithischen integrierten Schaltung (90) implementiert ist,

wobei der erste und der zweite Massepegel (Gnd1, Gnd2) in der monolithischen integrierten Schaltung (90) intern voneinander isoliert sind.

7. Eine Motorstromerfassungsschaltung vom oberseitigen Typ nach Anspruch 5,

wobei die Verstärkerschaltung (10) in der Form einer monolithischen integrierten Schaltung (90) implementiert ist,

wobei die monolithische integrierte Schaltung (90) umfasst:

den Operationsverstärker (11);

den ersten und zweiten Widerstand (R11, R12);

den pegelschiebezweckbestimmten PNP-Transistor (Q10);

einen ersten Anschluss (TVB), an den eine Energieversorgungsspannung (VB) von der Hauptenergieversorgungsschaltung (9, Cr) als eine Bezugsspannung für die Verstärkerschaltung (10) angelegt ist; und

einen zweiten Anschluss (TV3), an den ein Ende des dritten Widerstands (R13) angeschlossen ist, wobei der dritte Widerstand (R13) mit dem anderen Ende an dem ersten Anschluss (TVB) angeschlossen ist; und

wobei der erste und zweite Anschluss (TVB, TV3) nah beieinander angeordnet sind, und

wobei der dritte Widerstand (R13) extern von der monolithischen integrierten Schaltung (90) angeordnet ist.

8. Eine Motorstromerfassungsschaltung vom oberseitigen Typ nach Anspruch 1,
wobei Widerstände (R17, R18) jeweils in Serie mit Eingangsanschlüssen des Operationsverstärkers (11) verbunden sind.

## Revendications

1. Circuit du type à détection de courant de moteur du côté du haut potentiel, comprenant :

une pluralité de transistors à effet de champ FET (4a, 4d ; 4b, 4c) constituant un circuit en pont en H (4),
un moteur électrique (M) relié audit circuit en pont en H (4),
un moyen de commande (31) destiné à commander un sens d'une circulation de courant au travers dudit moteur électrique (M) et une intensité de ladite circulation de courant,
un circuit d'alimentation principale (9, Cr) destiné à fournir un courant de moteur (IM) audit circuit en pont en H (4) afin d'attaquer ledit moteur électrique (M),
une résistance de dérivation (Rs) insérée entre ledit circuit en pont en H (4) et ledit circuit d'alimentation principale (9, Cr),

caractérisé par

un circuit d'attaque de transistors FET (transistors à effet de champ) (7) destiné à attaquer lesdits transistors FET (4a, 4d ; 4b, 4c) avec des signaux à modulation PWM (modulés par largeur d'impulsion) conformément à un signal d'ordre (PW, LC, RC) émis par ledit moyen de commande (31),

un circuit échantillonneur-bloqueur (61) comprenant un commutateur analogique (Q1) destiné à échantillonner une tension (V1) détectée aux bornes de ladite résistance de dérivation (Rs) lorsque lesdits transistors à effet de champ (4a, 4d ; 4b, 4c) sont rendus conducteurs en synchronisme avec ledit signal d'ordre (PW, LC, RC), ledit circuit échantillonneur-bloqueur (61) mémorisant ladite tension (V1) lorsque lesdits transistors FET (4a, 4d ; 4b, 4c) sont rendus bloqués,

un circuit d'amplificateur (10) comprenant un amplificateur différentiel (11) destiné à amplifier la tension (V2) mémorisée par ledit circuit échantillonneur-bloqueur (61) afin de fournir ainsi une tension de détection (Vo) correspondant audit courant de moteur (IM) audit moyen de commande (31),

un circuit d'alimentation de tension négative (20) prévu entre ledit circuit échantillonneur-bloqueur (61) et ledit circuit d'amplificateur (10) afin de générer un premier niveau de masse (Gnd1) pour ledit circuit d'amplificateur (10), et

un circuit de génération de signal d'attaque de commutateur (62, 63) destiné à générer un signal d'attaque de commutateur (SD) afin de fermer/ouvrir ledit commutateur analogique (Q1) en synchronisme avec ledit signal d'ordre (PW, LC, RC),

dans lequel ledit circuit d'amplificateur (10) comprend un circuit à courant constant (Q10, R13, R14) destiné à décaler un niveau de tension de ladite tension de détection (Vo) vers un niveau de masse donné, et

dans lequel ledit premier niveau de masse (Gnd1) est isolé d'un second niveau de masse (Gnd2) destiné à d'autres circuits que ledit amplificateur différentiel (11) et est donné par une tension constante négative par référence à une tension d'alimentation (VB) dudit circuit d'alimentation principale (9, Cr), et

d'où il résulte que l'erreur d'amplification impliquée par l'amplification dudit signal de tension de détection (Vo) tel qu'il est produit par une variation de la tension (VB) dudit circuit d'alimentation principale (9, Cr) lors d'une circulation dudit courant de moteur (IM) au travers dudit moteur électrique (M) est supprimée.

2. Circuit du type à détection de courant de moteur du côté du haut potentiel selon la revendication 1,

dans lequel ledit amplificateur différentiel (11) comprend un circuit d'entrée à transistors de type NPN (Q11, ..., Q16), et

dans lequel ledit circuit d'alimentation de tension négative (20) comprend un condensateur (C21) inséré entre ledit circuit d'alimentation principale (9, Cr) et ledit second niveau de masse (Gnd2), une diode Zener (ZD) reliée en parallèle avec ledit condensateur (C21) et comportant une borne de cathode reliée audit circuit d'alimentation principale (9, Cr), et une résistance (R21) reliée en série avec une borne d'anode de ladite diode Zener (ZD), ledit premier niveau de masse (Gnd1) étant généré à partir de la borne d'anode de ladite diode Zener (ZD).

3. Circuit du type à détection de courant de moteur du côté du haut potentiel selon la revendication 1,

dans lequel ledit amplificateur différentiel (11B) comprend un circuit d'entrée à transistors de type PNP (Q22, Q21), et

dans lequel ledit circuit d'alimentation de tension négative (20B) comprend une alimentation à tension constante positive (ZD2, C22, R22) et une alimentation à tension constante négative (ZD, C21, R21) afin de générer des tensions constantes positive et négatives présentant des polarités positive et négatives, respectivement, par référence à la tension d'alimentation (VB) dudit circuit d'alimentation principale (9, Cr).

4. Circuit du type à détection de courant de moteur du côté du haut potentiel selon la revendication 1,

dans lequel ledit circuit de génération de signal d'attaque de commutateur (62, 63) comprend un circuit à retard (63) destiné à établir des temps de retard différents, respectivement, pour la montée et la descente dudit signal d'attaque de commutateur (SD).

5. Circuit du type à détection de courant de moteur du côté du haut potentiel selon la revendication 1,

ledit circuit à courant constant comprenant :

un transistor de type PNP réservé au décalage de niveau (Q10) prévu du côté de la sortie dudit circuit d'amplificateur (10) et ayant une base reliée à la borne de sortie dudit amplificateur différentiel,

une première résistance (R11) insérée entre une borne d'entrée inverseuse dudit amplificateur différentiel (11) et ledit circuit d'alimentation principale (9, Cr),

une seconde résistance (R12) insérée entre ladite borne d'entrée inverseuse dudit amplificateur différentiel (11, 11B) et une borne d'émetteur dudit transistor de type PNP réservé au décalage de niveau (Q10),

une troisième résistance (R13) insérée entre ledit circuit d'alimentation principale (9, Cr) et la borne d'émetteur dudit transistor de type PNP réservé au décalage de niveau (Q10), et une quatrième résistance (R14) insérée entre une borne de collecteur dudit transistor de type PNP réservé au décalage de niveau (Q10) et ledit second niveau de masse (Gnd2),

dans lequel un premier gain dudit circuit d'amplificateur (10) est déterminé par lesdites première et seconde résistances (R11, R12), alors qu'un second gain dudit circuit d'amplificateur (10) est déterminé par lesdites troisième et quatrième résistances (R13, R14).

6. Circuit du type à détection de courant de moteur du côté du haut potentiel selon la revendication 1,

ledit circuit de détection de courant de moteur (50) étant réalisé sous forme d'un circuit intégré monolithique (90),

dans lequel lesdits premier et second niveaux de masses (Gnd1, Gnd2) sont isolés l'un de l'autre de façon interne audit circuit intégré monolithique (90).

7. Circuit du type à détection de courant de moteur du côté du haut potentiel selon la revendication 5,

ledit circuit d'amplificateur (10) étant réalisé sous forme d'un circuit intégré monolithique (90),

dans lequel ledit circuit intégré monolithique (90) comprend

ledit amplificateur différentiel (11),
lesdites première et seconde résistances (R11, R12),
ledit transistor de type PNP réservé au décalage de niveau (Q10),
une première borne (TVB) à laquelle une tension d'alimentation (VB) est appliquée depuis ledit circuit d'alimentation principale (9, Cr) en tant que tension de référence pour ledit circuit d'amplificateur (10), et
une seconde borne (TV3) à laquelle une première extrémité de ladite troisième résistance (R13) est reliée, ladite troisième résistance (R13) ayant l'autre extrémité reliée à ladite première borne (TVB), et
dans lequel lesdites première et seconde bornes (TVB, TV3) sont disposées de façon rapprochée l'une de l'autre, et
dans lequel ladite troisième résistance (R13) est disposée de façon externe audit circuit intégré monolithique (90).

8. Circuit du type à détection de courant de moteur du côté du haut potentiel selon la revendication 1,

dans lequel des résistances (R17, R18) sont reliées en série aux bornes d'entrée dudit amplificateur différentiel (11), respectivement.

## FIG. 1

SAMPLE-AND-HOLD CIRCUIT

NEGATIVE VOLTAGE POWER-SUPPLY CIRCUIT

AMPLIFIER CIRCUIT

VB
Rs
CR
V1
Q1
R1
C1
V2
61
SD
GATE CIRCUIT 62
DELAY CIRCUIT 63
PR
ZD
VZ
C21
R21
20
VOP
R16
R17
R15
11
Gnd1
R11
R12
R13
Q10
R14
10
V3
Vo
Gnd2
31
A/D
Gnd
CONTROL UNIT
PW
LC
RC
4
H-BRIDGE CIRCUIT
IM
M
Gnd2
7
FET DRIVING CIRCUIT

# FIG. 2

# FIG. 3

FROM
CONTROL
UNIT 31

PW

R4  R5  Vth1  PR

Q6

R2  30

Q7  R3  V4  LC  SD

C3  RC  64  65

DELAY CIRCUIT  GATE CIRCUIT

63  62

TO SAMPLE-
AND-HOLD
CIRCUIT 61

# FIG. 4

COUNTERCLOCKWISE
DIRECTION
INDICATING SIGNAL LC

CLOCKWISE DIRECTION
INDICATING SIGNAL RC

PWM SIGNAL PW

INTEGRATED VOLTAGE
V4            Vth1

PWM DELAY SIGNAL PR

SWITCH DRIVING SIGNAL SD

VGS OF FET 4a

VGS OF FET 4d

VGS OF FET 4b

VGS OF FET 4c

MOTOR OFF | CLOCKWISE MOTOR ROTATION | COUNTER-CLOCKWISE MOTOR ROTATION | MOTOR OFF

$\tau 2$    $\tau 1$

# FIG. 5

VGS OF FET 4a,4d

PWM SIGNAL PW

SWITCH DRIVING SIGNAL SD

SHUNT VOLTAGE V1

HOLD VOLTAGE V2
AMPLIFIED VOLTAGE V3

FIRST GROUND LEVEL Gnd1

SECOND GROUND LEVEL Gnd2

POWER-SUPPLY VOLTAGE VB

DETECTION VOLTAGE VO

MOTOR CURRENT IM

# FIG. 6

BOOSTER POWER-SUPPLY CIRCUIT  22

NEGATIVE VOLTAGE POWER-SUPPLY CIRCUIT  20B

R22  C22  ZD2  ZD  C21  R21

DIFFERENTIAL AMPLIFIER  11B

Vop  VBE  12B  Q21  Q22  Q23  Q24  Gnd1  VBE

TO LEVEL SHIFTING PNP-TRANSISTOR Q10

SAMPLE-AND-HOLD CIRCUIT  61

FROM GATE CIRCUIT 62  SD

VB  RS

H-BRIDGE CIRCUIT  4

# FIG. 7

EP 0 827 266 B1

# FIG. 8

# FIG. 9

# FIG. 10
## PRIOR ART

TORQUE SENSOR 1

SPEED SENSOR 2

RLY CONTROLLER 3
T
SP
FB
RP
LP
RL
LL

Vd

56 DC SMOOTHING CIRCUIT

55 51 WAVEFORM SHAPING CIRCUIT

57 TIMING CLOCK GENERATING CIRCUIT

MOTOR CURRENT DETECTING CIRCUIT

V1

RS

RELAY 6

5

8

9

7a
7b
7c
7d

4a 4b
CLOCK-WISE
M
COUNTER-CLOCK-WISE
4c 4d

7e
7f

4

EP 0 827 266 B1

**FIG. 11**
PRIOR ART

MOTOR CURRENT DETECTING CIRCUIT

50

51

52

53

54

Vr

Vr

Vr

Vd

V1

RS

8

9

4

H-BRIDGE CIRCUIT

M

IM

# FIG. 12
## PRIOR ART

# FIG. 13
## PRIOR ART

# FIG. 14
## PRIOR ART

# FIG. 15
## PRIOR ART

SHUNT VOLTAGE V1

POWER-SUPPLY VOLTAGE VB

MOTOR CURRENT IM